(19) Europäisches Patentamt / European Patent Office / Office européen des brevets

(11) **EP 4 548 394 B1**

(12) **EUROPEAN PATENT SPECIFICATION**

(45) Date of publication and mention of the grant of the patent:
**10.06.2026 Bulletin 2026/24**

(21) Application number: **23734641.6**

(22) Date of filing: **22.06.2023**

(51) International Patent Classification (IPC):
**H10H 29/24** *(2026.01)*     **H10H 29/851** *(2025.01)*

(52) Cooperative Patent Classification (CPC):
**H10H 29/24; H10H 29/8512**

(86) International application number:
**PCT/EP2023/067002**

(87) International publication number:
**WO 2024/002864 (04.01.2024 Gazette 2024/01)**

(54) **PHOSPHOR CONVERTED LED LIGHT SOURCE COMPRISING UV LEDS WITH TAKING INTO ACCOUNT THE EXCITATION SPECTRUM OF THE PHOSPHOR**

IN PHOSPHOR UMGEWANDELTE LED-LICHTQUELLE, DIE UV-LEDS UMFASST, UNTER BERÜCKSICHTIGUNG DES ANREGUNGSSPEKTRUMS DES PHOSPHORS

SOURCE LUMINEUSE CONVERTIE EN PHOSPHORE DEL COMPRENANT DES DEL UV AVEC PRISE EN COMPTE DU SPECTRE D'EXCITATION DU PHOSPHORE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **01.07.2022 EP 22182595**

(43) Date of publication of application:
**07.05.2025 Bulletin 2025/19**

(73) Proprietor: **Signify Holding B.V.**
**5656 AE Eindhoven (NL)**

(72) Inventors:
• **VAN BOMMEL, Ties**
**5656 AE Eindhoven (NL)**

• **HIKMET, Rifat, Ata, Mustafa**
**5656 AE Eindhoven (NL)**

(74) Representative: **Verweij, Petronella Daniëlle**
**Signify Netherlands B.V.**
**Intellectual Property**
**High Tech Campus 7**
**5656 AE Eindhoven (NL)**

(56) References cited:
**WO-A1-2017/131715      WO-A1-2020/114894**
**CN-A- 111 380 002      US-A1- 2018 368 218**
**US-B1- 11 006 493**

**Description**

FIELD OF THE INVENTION

The invention relates to a system to generate light. The invention further relates to a lighting device.

BACKGROUND OF THE INVENTION

Wavelength converting lighting systems are known in the art. US20190139943A1, for instance, describes a lighting apparatus, a first group of at least one first solid state emitter, each first solid state emitter including a first light emitting diode ("LED") that, when excited, emits light having a peak wavelength in a range between about 440 nm and about 475 nm, and a second group of at least one second solid state emitter, each second solid state emitter comprising a second LED that, when excited, emits light having a peak wavelength in a range between about 390 nm and about 415 nm.
US11006493B discloses a lighting system that combines UV-A and white light with an adjustable CCT value so that any adverse effects from the UV-A radiation are mitigated. The device has tunable adjustments to the output of the non-UV LEDs, resulting in an overall mixed output conforming to a target CCT value.
WO2017/131715A1 discloses a device for generating tunable white light with controllable circadian energy performance. A plurality of LED strings generates light with color points that fall within blue, yellow/green, red, and cyan color ranges, with each LED string being driven with a separately controllable drive current in order to tune the generated light output. Different light emitting modes can be selected that utilize different combinations of the plurality of LED strings in order to tune the generated white light. One or more of the LED strings may have ultraviolet or violet LEDs.

SUMMARY OF THE INVENTION

While white LED sources can give an intensity of e.g. up to about 300 lm/mm$^2$; static phosphor converted laser white sources can give an intensity even up to about 20.000 lm/mm$^2$. Ce doped garnets (e.g. YAG, LuAG) may be the most suitable luminescent convertors which can be used for pumping with blue laser light as the garnet matrix has a very high chemical stability. Further, at low Ce concentrations (e.g. below 0.5%) temperature quenching may only occur above about 200 °C. Furthermore, emission from Ce has a very fast decay time so that optical saturation can essentially be avoided. Assuming e.g. a reflective mode operation, blue laser light may be incident on a phosphor. This may in embodiments realize almost full conversion of blue light, leading to emission of converted light. It is for this reason that the use of garnet phosphors with relatively high stability and thermal conductivity is suggested. However, also other phosphors may be applied.
UV light has been used for disinfection for over 100 years. Wavelengths between about 190 nm and 300 nm may be strongly absorbed by nucleic acids, which may result in defects in an organism's genome. This may be desired for inactivating (killing), bacteria and viruses, but may also have undesired side effects for humans. Therefore, the selection of wavelength of radiation, intensity of radiation and duration of irradiation may be limited in environments where people may reside such as offices, public transport, cinema's, restaurants, shops, etc., thus limiting the disinfection capacity. Especially in such environments, additional measures of disinfection may be advantageous to prevent the spread of bacteria and viruses such as influenza or novel (corona) viruses like COVID-19, SARS, and MERS.
It appears desirable to produce systems, which provide alternative ways for air treatment, such as disinfection. Further, existing systems for disinfection may not easily be implemented in existing infrastructure, such as in existing buildings like offices, hospitality areas, etc. and/or may not easily be able to serve larger spaces. This may again increase the risk of contamination. Further, incorporation in HVAC systems may not lead to desirable effects and appears to be relatively complex. Further, existing systems may not be efficient, or may be relatively bulky, and may also not easily be incorporated in functional devices, such as e.g. luminaires.
Hence, it is an aspect of the invention to provide an alternative phosphor converted LED light source, which preferably further at least partly obviates one or more of above-described drawbacks. The present invention may have as object to overcome or ameliorate at least one of the disadvantages of the prior art, or to provide a useful alternative.
According to a first aspect, the invention provides a light generating system. In embodiments, the light generating system comprises (a) a plurality of sets of light generating devices and (b) a luminescent material configured to generate visible light. Especially, the light generating devices may be configured in an array. Further, in embodiments, the light generating devices may be configured to generate device light. Especially, the light generating devices may comprise solid state light sources. The plurality of sets of light generating devices may, in embodiments, comprise at least two sets, more especially at least three sets of light generating devices. Especially, light generating devices of different sets may mutually differ in peak wavelengths of the device light. In embodiments, a first set of first light generating devices may be configured to provide first device light having a first peak wavelength ($\lambda 1$) in the visible wavelength range, especially in the blue wavelength range 440-495 nm. Further, in embodiments, a second set of second light generating devices may be configured to generate second device light having a second peak wavelength ($\lambda 2$) in the UV wavelength range or in the violet wavelength range 380-440 nm. Yet further, in embodiments, an optional third set of third light generating devices may be configured to generate third device light having a third peak wavelength ($\lambda 3$) in the UV wavelength range or in the violet wavelength range 380-440 nm. In embodiments, the luminescent material may be configured downstream of the array of light generating devices. Especially, the luminescent material may be configured to convert at least part of the first device light into luminescent material light. More especially, the luminescent material may be configured to convert at least part of the second device light and/or at least part of the third device light into luminescent material light. Further, in embodiments, the luminescent material may have different excitation intensities at the different peak wavelengths ($\lambda 1$, $\lambda 2$, $\lambda 3$). In embodiments, the light generating devices of the at least two, more especially the at least three sets, may be configured according to increasing or decreasing excitation intensities of the luminescent material for the different excitation intensities at the different peak wavelengths. The light generating devices and the luminescent material are configured such that at least part of the second device light and/or at least part of the third device light is transmitted by the luminescent material. Hence, in specific embodiments, the invention may provide a light generating system comprising (a) a plurality of sets of light generating devices and (b) a luminescent material, wherein the light generating devices are configured in an array; wherein the light generating devices are configured to generate device light; wherein the light generating devices comprise solid state light sources; wherein the plurality of sets of light generating devices comprises at least three sets of light generating devices, wherein light generating devices of different sets mutually differ in peak wavelengths of the device light, wherein a first set of first light generating devices is configured to provide first device light having a first peak wavelength ($\lambda 1$) in the blue wavelength range, a second set of second light generating devices is configured to generate second device light having a second peak wavelength ($\lambda 2$) in the UV wavelength range or in the violet wavelength range, and a third set of third light generating devices is configured to generate third device light having a third peak wavelength ($\lambda 3$) in the UV wavelength range or in the violet wavelength range; wherein the luminescent material is configured downstream of the array of light generating devices; wherein the luminescent material is configured to convert at least part of the first device light into luminescent material light, and wherein in specific embodiments the luminescent material is configured to convert at least part of the second device light and/or at least part of the third device light into luminescent material light; wherein the luminescent material has different excitation intensities at the different peak wavelengths ($\lambda 1$, $\lambda 2$, $\lambda 3$); wherein the light generating devices of the at least three sets are configured in the array according to increasing or decreasing excitation intensities of the luminescent material for the different excitation intensities at the different peak wavelengths, taking into account the excitation spectrum of the luminescent material. Hence, the invention may provide a phosphor converted LED light source, e.g. LED filament or a COB comprising UV LED, while taking into account the excitation spectrum of the luminescent material.

With such an invention, the light generating system may provide system light comprising a plurality of different wavelengths. Further, the system may especially provide such light by using a luminescent material, where the device light may be used to excite the luminescent material and provide luminescent material light. With the system, it may be possible to locate wavelengths that are converted less, but which may be in the UV or violet, at an edge of a radiation emitting surface, whereas the luminescent material light may essentially escape from a central part of a radiation emitting surface. Further, the system may be provided in a single unit comprising a plurality of light generating devices, which may be particularly useful in many situations in practical use such as for home, work, industrial lighting (where it may be difficult to accommodate a complicated arrangement of many lighting devices). Yet further, the system may be used to provide visible light or UV light and/or violet light, while it may also be possible to provide different types of light at the same time. Further, with such an invention, a light generating system may be provided such that it may be used for disinfection in addition to illumination. Especially, such a light generating system may provide UV light and/or violet light which may be useful for killing harmful microorganisms.

UV light has been used for disinfection for over 100 years. Wavelengths between about 190 nm and 300 nm may be strongly absorbed by nucleic acids, which may result in defects in an organism's genome. This may be desired for inactivating (killing), bacteria and viruses, but may also have undesired side effects for humans. Therefore, the selection of wavelength of radiation, intensity of radiation and duration of irradiation may be limited in environments where people may reside such as offices, public transport, cinema's, restaurants, shops, etc., thus limiting the disinfection capacity. Especially in such environments, additional measures of disinfection may be advantageous to prevent the spread of bacteria and viruses such as influenza or novel (corona) viruses like COVID-19, SARS and MERS. It appears desirable to produce systems, which provide alternative ways for air treatment, such as disinfection. Further, existing systems for disinfection may not easily be implemented in existing infrastructure, such as in existing buildings like offices, hospitality areas, etc. and/or may not easily be able to serve larger spaces. This may again increase the risk of contamination. Further, incorporation in HVAC systems may not lead to desirable effects and appears to be relatively complex. Further, existing systems may not be efficient, or may be relatively bulky, and may also not easily be incorporated in functional devices, such as e.g. luminaires. Other disinfection systems may use one or more anti-microbial and/or anti-viral means to disinfect a space or an object. Examples of such means may be chemical agents which may raise concerns. For instance, the chemical agents may also be harmful for people and pets.

In embodiments, the disinfecting light, may especially comprise ultraviolet (UV) radiation (and/or optionally violet radiation), i.e., the light may comprise a wavelength selected from the ultraviolet wavelength range (and/or optionally the violet wavelength range). However, other wavelengths are herein not excluded. The ultraviolet wavelength range is defined as light in a wavelength range from 100 to 380 nm and can be divided into different types of UV light / UV wavelength ranges (Table 1). Different UV wavelengths of radiation may have different properties and thus may have different compatibility with human presence and may have different effects when used for disinfection (Table 1).

Table 1: Properties of different types of UV, violet, and NIR wavelength light

| Name | Short name | Wavelength (nm) | (Relative) sterilization effectiveness | | Safe Radiation | Vitamin D generation | Ozone generation |
|---|---|---|---|---|---|---|---|
| | | | Bacteria | Viruses | | | |
| Near Infrared (deep red) | NIR | 780-950 | + | +/- | +++ | | |
| Violet | V | 380-420 | +/- | - | + | | |
| Ultraviolet A | UV-A | 315-380 | + | - | + | | |
| Ultraviolet B | UV-B | 280-315 | + | +/- | +/- | + | |
| Near ultraviolet C | Near UV-C | 230-280 | ++ | ++ | - | | |
| Far ultraviolet C | Far UV-C | 190-230 | +++ | +++ | + | | +/- |
| Extreme ultraviolet C | Extreme UV-C | 100-190 | +++ | +++ | - | | + |

Each UV type / wavelength range may have different benefits and/or drawbacks. Relevant aspects may be (relative) sterilization effectiveness, safety (regarding radiation), and ozone production (as result of its radiation). Depending on an application a specific type of UV light or a specific combination of UV light types may be selected and provides superior performance over other types of UV light. UV-A may be (relatively) safe and may inactivate (kill) bacteria, but may be less effective in inactivating (killing) viruses. UV-B may be (relatively) safe when a low dose (i.e. low exposure time and/or low intensity) is used, may inactivate (kill) bacteria, and may be moderately effective in inactivating (killing) viruses. UV-B may also have the additional benefit that it can be used effectively in the production of vitamin D in a skin of a person or animal. Near UV-C may be relatively unsafe, but may effectively inactivating, especially kill bacteria and viruses. Far UV-C may also be effective in inactivating (killing) bacteria and viruses, but may be (relatively to other UV-C wavelength ranges) (rather) safe. Far-UV light may generate some ozone which may be harmful for human beings and animals. Extreme UV-C may also be effective in inactivating (killing) bacteria and viruses, but may be relatively unsafe. Extreme UV-C may generate ozone which may be undesired when exposed to human beings or animals. In some application ozone may be desired and may contribute to disinfection, but then its shielding from humans and animals may be desired. Hence, in the table "+" for ozone production especially implies that ozone is produced which may be useful for disinfection applications, but may be harmful for humans / animals when they are exposed to it. Hence, in many applications this "+" may actually be undesired while in others, it may be desired. The types of light indicated in above table may in embodiments be used to sanitize air and/or surfaces.

The terms "inactivating" and "killing" with respect to a virus may herein especially refer to damaging the virus in such a way that the virus can no longer infect and/or reproduce in a host cell, i.e., the virus may be (essentially) harmless after inactivation or killing.

Hence, in embodiments, the light may comprise a wavelength in the UV-A range. In further embodiments, the light may comprise a wavelength in the UV-B range. In further embodiments, the light may comprise a wavelength in the Near UV-C range. In further embodiments, the light may comprise a wavelength in the Far UV-C range. In further embodiments, the light may comprise a wavelength in the extreme UV-C range. The Near UV-C, the Far UV-C and the extreme UV-C ranges may herein also collectively be referred to as the UV-C range. Hence, in embodiments, the light may comprise a wavelength in the UV-C range. In other embodiments, the light may comprise violet radiation. Hence, UV and/or violet light or radiation described herein may also be indicated as disinfection light.

As mentioned before, the invention may provide a light generating system (or "system") configured to generate system light, wherein the light generating system may comprise (a) a plurality of sets of light generating devices and (b) a luminescent material. Especially, the light generating devices may be configured in an array, for example the light generating devices may be arranged along a line or alternatively, the light generating devices may be arranged in a 1D array or 2D array. The array may be regular, random, or quasi random. Especially, in embodiments the array may be a regular 1D array or a regular 2D array. However, other arrays, like a phyllotaxis tessellation or a sunflower tessellation, may also be possible. Especially, however, the array may be a regular array. In embodiments, the array is an n*m array, wherein n and m are each individually selected from the range of at least 3. In specific embodiments, n and m are each individually selected from the range of 3-100. Hence, in embodiments there may be one or two constant pitches. The term "tessellation" may herein especially refer to a pattern of (repeated) shapes, especially polygons, which fit together closely without gaps or overlapping. Note however, that the array may also be a 1D array, such as e.g. when a filament is applied.

Further, in embodiments, the light generating devices may be configured to generate device light. Here, "device light" is different from "system light". Device light may refer to light generated by the one or more light generating devices. System light may refer to the light generated by the light generating system. Especially, the system light may comprise the device light. Further, the system light may (also) comprise other light, for example luminescent material light (or "converted device light", or "converted light").

In embodiments, the light generating device may not be limited only to a device to generate device light i.e. in embodiments, the light generating device may also comprise additional components or a package of light generating elements such as mirrors, lenses, reflectors, collimators, etc. to facilitate generation and propagation of light. Hence, the light generating device may not be limited to a light source, but may be a device comprising the light source and additional elements to provide or generate device light.

A light generating device may especially be configured to generate device light. Especially, the light generating device may comprise a light source. The light source may especially configured to generate light source light. In embodiments, the device light may essentially consist of the device light. In other embodiments, the device light may essentially consist of converted light source light. In yet other embodiments, the device light may comprise (unconverted) light source light and converted light source light. Light source light may be converted with a luminescent material into luminescent material light and/or with an upconverter into upconverted light (see also below). The term "light generating device" may also refer to a plurality of light generating devices which may provide device light having essentially the same spectral power distributions. In specific embodiments, the term "light generating device" may also refer to a plurality of light generating devices which may provide device light having different spectral power distributions.

The term "light source" may in principle relate to any light source known in the art. It may be a conventional (tungsten) light bulb, a low pressure mercury lamp, a high pressure mercury lamp, a fluorescent lamp, an LED (light emissive diode). In a specific embodiment, the light source comprises a solid state LED light source (such as an LED or laser diode (or "diode laser")). The term "light source" may also relate to a plurality of light sources, such as 2-2000 (solid state) LED light sources. Hence, the term LED may also refer to a plurality of LEDs. Further, the term "light source" may in embodiments also refer to a so-called chips-on-board (COB) light source. The term "COB" especially refers to LED chips in the form of a semiconductor chip that is neither encased nor connected but directly mounted onto a substrate, such as a PCB. Hence, a plurality of light emitting semiconductor light source may be configured on the same substrate. In embodiments, a COB is a multi LED chip configured together as a single lighting module. The term "light source" may also refer to a chip scaled package (CSP). A CSP may comprise a single solid state die with provided thereon a luminescent material comprising layer. The term "light source" may also refer to a midpower package. A midpower package may comprise one or more solid state die(s). The die(s) may be covered by a luminescent material comprising layer. The die dimensions may be equal to or smaller than 2 mm, such as in the range of e.g. 0.2-2 mm. Hence, in embodiments the light source comprises a solid state light source. Further, in specific embodiments, the light source comprises a chip scale packaged LED. Herein, the term "light source" may also especially refer to a small solid state light source, such as having a mini size or micro size. For instance, the light sources may comprise one or more of mini LEDs and micro LEDs. Especially, in embodiment the light sources comprise micro LEDs or "microLEDs" or "$\mu$LEDs". Herein, the term mini size or mini LED especially indicates to solid state light sources having dimensions, such as die dimension, especially length and width, selected from the range of 100 $\mu$m - 1 mm. Herein, the term $\mu$ size or micro LED especially indicates to solid state light sources having dimensions, such as die dimension, especially length and width, selected from the range of 100 $\mu$m and smaller.

The light source may have a light escape surface. Referring to conventional light sources such as light bulbs or fluorescent lamps, it may be an outer surface of a glass or a quartz envelope. For LED's it may for instance be the LED die, or when a resin is applied to the LED die, the outer surface of the resin. In principle, it may also be the terminal end of a fiber. The term escape surface especially relates to that part of the light source, where the light actually leaves or escapes from the light source. The light source is configured to provide a beam of light. This beam of light (thus) escapes from the light exit surface of the light source.

Likewise, a light generating device may comprise a light escape surface, such as an end window. Further, likewise a light generating system may comprise a light escape surface, such as an end window.

The term "light source" may refer to a semiconductor light-emitting device, such as a light emitting diode (LEDs), a resonant cavity light emitting diode (RCLED), a vertical cavity laser diode (VCSELs), an edge emitting laser, etc... The term "light source" may also refer to an organic light-emitting diode (OLED), such as a passive-matrix (PMOLED) or an active-matrix (AMOLED). In a specific embodiment, the light source comprises a solid-state light source (such as an LED or laser diode). In an embodiment, the light source comprises an LED (light emitting diode). The terms "light source" or "solid state light source" may also refer to a superluminescent diode (SLED). The term LED may also refer to a plurality of LEDs. The term "light source" may also relate to a plurality of (essentially identical (or different)) light sources, such as 2-2000 solid state light sources. In embodiments, the light source may comprise one or more micro-optical elements (array of micro lenses) downstream of a single solid-state light source, such as an LED, or downstream of a plurality of solid-state light sources (i.e. e.g. shared by multiple LEDs). In embodiments, the light source may comprise an LED with on-chip optics. In embodiments, the light source comprises pixelated single LEDs (with or without optics) (offering in embodiments on-chip beam steering). In embodiments, the light source may be configured to provide primary radiation, which is used as such, such as e.g. a blue light source, like a blue LED, or a green light source, such as a green LED, and a red light source, such as a red LED. Such LEDs, which may not comprise a luminescent material ("phosphor") may be indicated as direct color LEDs. In other embodiments, however, the light source may be configured to provide primary radiation and part of the primary radiation is converted into secondary radiation. Secondary radiation may be based on conversion by a luminescent material. The secondary radiation may therefore also be indicated as luminescent material radiation. The luminescent material may in embodiments be comprised by the light source, such as an LED with a luminescent material layer or dome comprising luminescent material. Such LEDs may be indicated as phosphor converted LEDs or PC LEDs (phosphor converted LEDs). In other embodiments, the luminescent material may be configured at some distance ("remote") from the light source, such as an LED with a luminescent material layer not in physical contact with a die of the LED. Hence, in specific embodiments the light source may be a light source that during operation emits at least light at wavelength selected from the range of 380-470 nm. However, other wavelengths may also be possible. This light may partially be used by the luminescent material.

In embodiments, the light generating device may comprise a luminescent material. In embodiments, the light generating device may comprise a PC LED. In other embodiments, the light generating device may comprise a direct LED (i.e. no phosphor). In embodiments, the light generating device may comprise a laser device, like a laser diode. In embodiments, the light generating device may comprise a superluminescent diode. Hence, in specific embodiments, the light source may be selected from the group of laser diodes and superluminescent diodes. In other embodiments, the light source may comprise an LED.

The light source may especially be configured to generate light source light having an optical axis (O), (a beam shape,) and a spectral power distribution. The light source light may in embodiments comprise one or more bands, having band widths as known for lasers.

The term "light source" may (thus) refer to a light generating element as such, like e.g. a solid state light source, or e.g. to a package of the light generating element, such as a solid state light source, and one or more of a luminescent material comprising element and (other) optics, like a lens, a collimator. A light converter element ("converter element" or "converter") may comprise a luminescent material comprising element. For instance, a solid state light source as such, like a blue LED, is a light source. A combination of a solid state light source (as light generating element) and a light converter element, such as a blue LED and a light converter element, optically coupled to the solid state light source, may also be a light source (but may also be indicated as light generating device). Hence, a white LED is a light source (but may e.g. also be indicated as (white) light generating device).

The term "light source" herein may also refer to a light source comprising a solid state light source, such as an LED or a laser diode or a superluminescent diode.

The term "light source" may (thus) in embodiments also refer to a light source that is (also) based on conversion of light, such as a light source in combination with a luminescent converter material. Hence, the term "light source" may also refer to a combination of an LED with a luminescent material configured to convert at least part of the LED radiation, or to a combination of a (diode) laser with a luminescent material configured to convert at least part of the (diode) laser radiation.

In embodiments, the term "light source" may also refer to a combination of a light source, like an LED, and an optical filter, which may change the spectral power distribution of the light generated by the light source. Especially, the term "light generating device" may be used to address a light source and further (optical components), like an optical filter and/or a beam shaping element, etc.

The phrases "different light sources" or "a plurality of different light sources", and similar phrases, may in embodiments refer to a plurality of solid-state light sources selected from at least two different bins. Likewise, the phrases "identical light sources" or "a plurality of same light sources", and similar phrases, may in embodiments refer to a plurality of solid-state light sources selected from the same bin.

The term "solid state light source", or "solid state material light source", and similar terms, may especially refer to semiconductor light sources, such as a light emitting diode (LED), a diode laser, or a superluminescent diode.

In embodiments, the plurality of sets of light generating devices may comprise at least two sets of light generating devices, more especially at least three sets of light generating devices. Especially, light generating devices of different sets may mutually differ in peak wavelengths of the device light. The device light may have a spectral distribution of wavelengths, wherein a specific wavelength corresponding to the highest intensity may be the peak wavelength. Therefore, in embodiments, the (each) light generating device may have a unique peak wavelength and hence, the one or more light generating devices may have one or more peak wavelengths. Each set of the light generating devices has a different peak wavelength form the other sets.

In embodiments, the light generating system may comprise a plurality of sets of light generating devices, such as at least three sets, such as at least six sets, especially at least ten sets. Especially, the first set of first light generating devices may be configured to provide first device light having a first peak wavelength ($\lambda 1$). The first peak wavelength may especially be in the visible wavelength range, especially the blue wavelength range. Further, the second set of second light generating devices may be configured to generate second device light having a second peak wavelength ($\lambda 2$) in the UV wavelength range or in the violet wavelength range. Yet further, in embodiments, the (optional) third set of third light generating devices may be configured to generate third device light having a third peak wavelength ($\lambda 3$) in the UV wavelength range or in the violet wavelength range. Hence, both the second peak wavelength and the third peak wavelength may be in the UV-violet wavelength range.

The terms "violet light" or "violet emission" especially relates to light having a wavelength in the range of about 380-440 nm. The terms "blue light" or "blue emission" especially relates to light having a wavelength in the range of about 440-495 nm (including some violet and cyan hues). The terms "green light" or "green emission" especially relate to light having a wavelength in the range of about 495-570 nm. The terms "yellow light" or "yellow emission" especially relate to light having a wavelength in the range of about 570-590 nm. The terms "orange light" or "orange emission" especially relate to light having a wavelength in the range of about 590-620 nm. The terms "red light" or "red emission" especially relate to light having a wavelength in the range of about 620-780 nm. The term "pink light" or "pink emission" refers to light having a blue and a red component. The term "cyan" may refer to one or more wavelengths selected from the range of about 490-520 nm. The term "amber" may refer to one or more wavelengths selected from the range of about 585-605 nm, such as about 590-600 nm. The phrase "light having one or more wavelengths in a wavelength range" and similar phrases may especially indicate that the indicated light (or radiation) has a spectral power distribution with at least intensity or intensities at these one or more wavelengths in the indicate wavelength range. For instance, a blue emitting solid state light source will have a spectral power distribution with intensities at one or more wavelengths in the 440-495 nm wavelength range. The phrase "UV-violet", and similar phrases, may especially refer to radiation having a wavelength selected from the wavelength range of 100-440 nm.

In embodiments, the luminescent material may be configured downstream of the array of light generating devices. Here, the luminescent material may be configured along the path of the device light which escapes from the light generating device(s). The luminescent material may especially be configured to convert at least part of the first device light into luminescent material light. Further, in embodiments, at least a part of the second device light or at least part of third device light (or at least part of both) may be converted into luminescent material light. The luminescent material may convert light (for example device light) of one wavelength into light of another wavelength (such as the luminescent material light). However, the intensity of the converted luminescent material light may be in dependence of the wavelength of the device light incident on the luminescent material. Hence, in embodiments, the luminescent material may have different excitation intensities at the different peak wavelengths ($\lambda 1$, $\lambda 2$, $\lambda 3$). Hence, luminescent material light of high intensity may be generated by selecting the peak wavelength of the one or more sets of light generating devices equal to the wavelength at which the luminescent material has a high excitation intensity. Hence, in embodiments, the light generating devices of the at least three sets may be configured according to increasing or decreasing excitation intensities of the luminescent material for the different excitation intensities at the different peak wavelengths. Likewise, this may be done when there are only two sets of light generating devices, such as in a symmetrical arrangement, like concentric, or a linear $B_{n2}A_{n1}B_{n2}$ arrangement, wherein A refers to light generating devices of a first type, like first light generating devices, and $n1 \geq 1$, and B refers to light generating devices of a second type, such as second light generating devices, wherein $n2 \geq 1$, and wherein in specific embodiments $n1 > n2$.

Likewise, this may be done when there are only three sets of light generating devices, such as in a symmetrical arrangement, like concentric, or a linear $C_{n3}B_{n2}A_{n1}B_{n2}C_{n3}$ arrangement, wherein A refers to light generating devices of a first type, like first light generating devices, and $n1 \geq 1$, B refers to light generating devices of a second type, such as second light generating devices, wherein $n2 \geq 1$, C refers to light generating devices of a third type, such as third light generating devices, wherein $n3 \geq 1$. In specific embodiments $n1 > n2 > n3$.

The term "excitation intensity" of a luminescent material, as used in the specification and claims, means the "oscillator strength" of the luminescent material. In embodiments, a luminescent material and light generating devices are selected wherein the first light generating devices have a peak length at wavelength where the luminescent material has a first oscillator strength ($O_1$), and another type of light generating devices ($n$th type) having a peak wavelength $\lambda_n$ where the luminescent material has an nth oscillator strength ($O_n$), wherein $O_n/O_1 \leq 0.5$, such as $O_n/O_1 \leq 0.2$, like in embodiments $O_n/O_1 \leq 0.1$. The "another type" of light generating devices ($n$th type) may e.g. be the third light generating devices or if available the fourth light generating devices. In embodiments, the value of $O_n$ may decrease with the value of n.

Especially, the luminescent material may be configured in the transmissive mode. In the transmissive mode, it may be relatively easy to have light source light admixed in the luminescent material light, which may be useful for generating the desirable spectral power distribution. In the reflective mode, thermal management may be easier, as a substantial part of the luminescent material may be in thermal contact with a thermally conductive element, like a heatsink or heat spreader. Hence, would any device light escape from the system, in embodiments this may only via transmission through the luminescent material. Luminescent materials and embodiments comprising such are discussed in more detail (see further below).

The term "luminescent material" especially refers to a material that can convert first radiation, especially one or more of UV radiation and blue radiation, into second radiation. In general, the first radiation and second radiation have different spectral power distributions. Hence, instead of the term "luminescent material", also the terms "luminescent converter" or "converter" may be applied. In general, the second radiation has a spectral power distribution at larger wavelengths than the first radiation, which is the case in the so-called down-conversion. In specific embodiments, however the second radiation has a spectral power distribution with intensity at smaller wavelengths than the first radiation, which is the case in the so-called up-conversion.

The "luminescent material" refers to a material that can convert radiation into e.g. visible and/or infrared light. For instance, the luminescent material may be able to convert one or more of UV radiation and blue radiation, into visible light. The luminescent material may in specific embodiments also convert radiation into infrared radiation (IR). Hence, upon excitation with radiation, the luminescent material emits radiation. In general, the luminescent material will be a down converter, i.e. radiation of a smaller wavelength is converted into radiation with a larger wavelength ($\lambda_{ex}<\lambda_{em}$), though in specific embodiments the luminescent material may comprise up-converter luminescent material, i.e. radiation of a larger wavelength is converted into radiation with a smaller wavelength ($\lambda_{ex}>\lambda_{em}$).

In embodiments, the term "luminescence" may refer to phosphorescence. In embodiments, the term "luminescence" may also refer to fluorescence. Instead of the term "luminescence", also the term "emission" may be applied. Hence, the terms "first radiation" and "second radiation" may refer to excitation radiation and emission (radiation), respectively. Likewise, the term "luminescent material" may in embodiments refer to phosphorescence and/or fluorescence.

The term "luminescent material" may also refer to a plurality of different luminescent materials. Examples of possible luminescent materials are indicated below. Hence, the term "luminescent material" may in specific embodiments also refer to a luminescent material composition. Instead of the term "luminescent material" also the term "phosphor" may be applied. These terms are known to the person skilled in the art.

In embodiments, luminescent materials are selected from garnets and nitrides, especially doped with trivalent cerium or divalent europium, respectively. The term "nitride" may also refer to oxynitride or nitridosilicate, etc. Alternatively or additionally, the luminescent material(s) may be selected from silicates, especially doped with divalent europium.

In specific embodiments the luminescent material comprises a luminescent material of the type $A_3B_5O_{12}$:Ce, wherein A in embodiments comprises one or more of Y, La, Gd, Tb and Lu, especially (at least) one or more of Y, Gd, Tb and Lu, and wherein B in embodiments comprises one or more of Al, Ga, In and Sc. Especially, A may comprise one or more of Y, Gd and Lu, such as especially one or more of Y and Lu. Especially, B may comprise one or more of Al and Ga, more especially at least Al, such as essentially entirely Al. Hence, especially suitable luminescent materials are cerium comprising garnet materials. Embodiments of garnets especially include $A_3B_5O_{12}$ garnets, wherein A comprises at least yttrium or lutetium and wherein B comprises at least aluminum. Such garnets may be doped with cerium (Ce), with praseodymium (Pr) or a combination of cerium and praseodymium; especially however with Ce. Especially, B may comprise aluminum (Al); however, in addition to aluminum, B may also partly comprise gallium (Ga) and/or scandium (Sc) and/or indium (In), especially up to about 20% of B, more especially up to about 10 % of B (i.e. the B ions essentially consist of 90 or more mole % of Al and 10 or less mole % of one or more of Ga, Sc and In); B may especially comprise up to about 10% gallium. In another variant, B and O may at least partly be replaced by Si and N. The element A may especially be selected from the group consisting of yttrium (Y), gadolinium (Gd), terbium (Tb) and lutetium (Lu). Further, Gd and/or Tb are especially only present up to an amount of about 20% of A. In a specific embodiment, the garnet luminescent material comprises $(Y_{1-x}Lu_x)_3B_5O_{12}$:Ce, wherein x is equal to or larger than 0 and equal to or smaller than 1. The term ":Ce", indicates that part of the metal ions (i.e. in the garnets: part of the "A" ions) in the luminescent material is replaced by Ce. For instance, in the case of $(Y_{1-x}Lu_x)_3Al_5O_{12}$:Ce, part of Y and/or Lu is replaced by Ce. This is known to the person skilled in the art. Ce will replace A in general for not more than 10%; in general, the Ce concentration will be in the range of 0.1 to 4%, especially 0.1 to 2% (relative to A). Assuming 1% Ce and 10% Y, the full correct formula could be $(Y_{0.1}Lu_{0.89}Ce_{0.01})_3Al_5O_{12}$. Ce in garnets is substantially or only in the trivalent state, as is known to the person skilled in the art.

In embodiments, the luminescent material (thus) comprises $A_3B_5O_{12}$ wherein in specific embodiments at maximum 10% of B-O may be replaced by Si-N.

In specific embodiments the luminescent material comprises $(Y_{x1-x2-x3}A'_{x2}Ce_{x3})_3(Al_{y1-y2}B'_{y2})_5O_{12}$, wherein x1+x2+x3=1, wherein x3>0, wherein 0<x2+x3≤0.2, wherein y1+y2=1, wherein 0≤y2≤0.2, wherein A' comprises one or more elements selected from the group consisting of lanthanides, and wherein B' comprises one or more elements selected from the group consisting of Ga, In and Sc. In embodiments, x3 is selected from the range of 0.001-0.1. In the present invention, especially x1>0, such as >0.2, like at least 0.8. Garnets with Y may provide suitable spectral power distributions.

In specific embodiments at maximum 10% of B-O may be replaced by Si-N. Here, B in B-O refers to one or more of Al, Ga, In and Sc (and O refers to oxygen); in specific embodiments B-O may refer to Al-O. As indicated above, in specific embodiments x3 may be selected from the range of 0.001-0.04. Especially, such luminescent materials may have a suitable spectral distribution (see however below), have a relatively high efficiency, have a relatively high thermal stability, and allow a high CRI (optionally in combination with (the) light of other sources of light as described herein). Hence, in specific embodiments A may be selected from the group consisting of Lu and Gd. Alternatively or additionally, B may comprise Ga. Hence, in embodiments the luminescent material comprises $(Y_{x1-x2-x3}(Lu,Gd)_{x2}Ce_{x3})_3(Al_{y1-y2}Ga_{y2})_5O_{12}$, wherein Lu and/or Gd may be available. Even more especially, x3 is selected from the range of 0.001-0.1, wherein $0<x2+x3\leq0.1$, and wherein $0\leq y2\leq0.1$. Further, in specific embodiments, at maximum 1% of B-O may be replaced by SiN. Here, the percentage refers to moles (as known in the art); see e.g. also EP3149108. In yet further specific embodiments, the luminescent material comprises $(Y_{x1-x3}Ce_{x3})_3Al_5O_{12}$, wherein x1+x3=1, and wherein $0<x3\leq0.2$, such as 0.001-0.1.

In specific embodiments, the light generating device may only include luminescent materials selected from the type of cerium comprising garnets. In even further specific embodiments, the light generating device includes a single type of luminescent materials, such as $(Y_{x1-x2-x3}A'_{x2}Ce_{x3})_3(Al_{y1-y2}B'_{y2})_5O_{12}$. Hence, in specific embodiments the light generating device comprises luminescent material, wherein at least 85 weight%, even more especially at least about 90 wt.%, such as yet even more especially at least about 95 weight % of the luminescent material comprises $(Y_{x1-x2-x3}A'_{x2}Ce_{x3})_3(Al_{y1-y2}B'_{y2})_5O_{12}$. Here, wherein A' comprises one or more elements selected from the group consisting of lanthanides, and wherein B' comprises one or more elements selected from the group consisting of Ga, In and Sc, wherein x1+x2+x3=1, wherein x3>0, wherein $0<x2+x3\leq0.2$, wherein y1+y2=1, wherein $0\leq y2\leq0.2$. Especially, x3 is selected from the range of 0.001-0.1. Note that in embodiments x2=0. Alternatively or additionally, in embodiments y2=0.

In specific embodiments, A may especially comprise at least Y, and B may especially comprise at least Al.

Alternatively or additionally, wherein the luminescent material may comprises a luminescent material of the type $A_3Si_6N_{11}:Ce^{3+}$, wherein A comprises one or more of Y, La, Gd, Tb and Lu, such as in embodiments one or more of La and Y.

In embodiments, the luminescent material may alternatively or additionally comprise one or more of $MS:Eu^{2+}$ and/or $M_2Si_5N_8:Eu^{2+}$ and/or $MAlSiN_3:Eu^{2+}$ and/or $Ca_2AlSi_3O_2N_5:Eu^{2+}$, etc., wherein M comprises one or more of Ba, Sr and Ca, especially in embodiments at least Sr. Hence, in embodiments, the luminescent may comprise one or more materials selected from the group consisting of (Ba,Sr,Ca)S:Eu, (Ba,Sr,Ca)AlSiN_3:Eu and $(Ba,Sr,Ca)_2Si_5N_8$:Eu. In these compounds, europium (Eu) is substantially or only divalent, and replaces one or more of the indicated divalent cations. In general, Eu will not be present in amounts larger than 10% of the cation; its presence will especially be in the range of about 0.5 to 10%, more especially in the range of about 0.5 to 5% relative to the cation(s) it replaces. The term ":Eu", indicates that part of the metal ions is replaced by Eu (in these examples by $Eu^{2+}$). For instance, assuming 2% Eu in CaAlSiN_3:Eu, the correct formula could be $(Ca_{0.98}Eu_{0.02})AlSiN_3$. Divalent europium will in general replace divalent cations, such as the above divalent alkaline earth cations, especially Ca, Sr or Ba. The material (Ba,Sr,Ca)S:Eu can also be indicated as MS:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca). Further, the material $(Ba,Sr,Ca)_2Si_5N_8$:Eu can also be indicated as $M_2Si_5N_8$:Eu, wherein M is one or more elements selected from the group consisting of barium (Ba), strontium (Sr) and calcium (Ca); especially, M comprises in this compound Sr and/or Ba. In a further specific embodiment, M consists of Sr and/or Ba (not taking into account the presence of Eu), especially 50 to 100%, more especially 50 to 90% Ba and 50 to 0%, especially 50 to 10% Sr, such as $Ba_{1.5}Sr_{0.5}Si_5N_8$:Eu (i.e. 75 % Ba; 25% Sr). Here, Eu is introduced and replaces at least part of M, i.e. one or more of Ba, Sr, and Ca). Likewise, the material (Ba,Sr,Ca)AlSiN_3:Eu can also be indicated as MAlSiN_3:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca). Eu in the above indicated luminescent materials is substantially or only in the divalent state, as is known to the person skilled in the art.

In embodiments, a red luminescent material may comprise one or more materials selected from the group consisting of (Ba,Sr,Ca)S:Eu, (Ba,Sr,Ca)AlSiN_3:Eu and $(Ba,Sr,Ca)_2Si_5N_8$:Eu. In these compounds, europium (Eu) is substantially or only divalent, and replaces one or more of the indicated divalent cations. In general, Eu will not be present in amounts larger than 10% of the cation; its presence will especially be in the range of about 0.5 to 10%, more especially in the range of about 0.5 to 5% relative to the cation(s) it replaces. The term ":Eu", indicates that part of the metal ions is replaced by Eu (in these examples by $Eu^{2+}$). For instance, assuming 2% Eu in CaAlSiN_3:Eu, the correct formula could be $(Ca_{0.98}Eu_{0.02})AlSiN_3$. Divalent europium will in general replace divalent cations, such as the above divalent alkaline earth cations, especially Ca, Sr or Ba.

The material (Ba,Sr,Ca)S:Eu can also be indicated as MS:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca).

Further, the material $(Ba,Sr,Ca)_2Si_5N_8$:Eu can also be indicated as $M_2Si_5N_8$:Eu, wherein M is one or more elements selected from the group consisting of barium (Ba), strontium (Sr) and calcium (Ca); especially, M comprises in this compound Sr and/or Ba. In a further specific embodiment, M consists of Sr and/or Ba (not taking into account the presence of Eu), especially 50 to 100%, more especially 50 to 90% Ba and 50 to 0%, especially 50 to 10% Sr, such as $Ba_{1.5}Sr_{0.5}Si_5N_8$:Eu (i.e. 75 % Ba; 25% Sr). Here, Eu is introduced and replaces at least part of M, i.e. one or more of Ba, Sr, and Ca).

Likewise, the material $(Ba,Sr,Ca)AlSiN_3$:Eu can also be indicated as $MAlSiN_3$:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca).

Eu in the above indicated luminescent materials is substantially or only in the divalent state, as is known to the person skilled in the art.

Blue luminescent materials may comprise YSO ($Y_2SiO_5$:$Ce^{3+}$), or similar compounds, or BAM ($BaMgAl_{10}O_{17}$:$Eu^{2+}$), or similar compounds.

The term "luminescent material" herein especially relates to inorganic luminescent materials.

Alternatively or additionally, also other luminescent materials may be applied. For instance quantum dots and/or organic dyes may be applied and may optionally be embedded in transmissive matrices like e.g. polymers, like PMMA, or polysiloxanes, etc. etc.. Quantum dots are small crystals of semiconducting material generally having a width or diameter of only a few nanometers. When excited by incident light, a quantum dot emits light of a color determined by the size and material of the crystal. Light of a particular color can therefore be produced by adapting the size of the dots. Most known quantum dots with emission in the visible range are based on cadmium selenide (CdSe) with a shell such as cadmium sulfide (CdS) and zinc sulfide (ZnS). Cadmium free quantum dots such as indium phosphide (InP), and copper indium sulfide ($CuInS_2$) and/or silver indium sulfide ($AgInS_2$) can also be used. Quantum dots show very narrow emission band and thus they show saturated colors. Furthermore the emission color can easily be tuned by adapting the size of the quantum dots. Any type of quantum dot known in the art may be used in the present invention. However, it may be preferred for reasons of environmental safety and concern to use cadmium-free quantum dots or at least quantum dots having a very low cadmium content. Instead of quantum dots or in addition to quantum dots, also other quantum confinement structures may be used. The term "quantum confinement structures" should, in the context of the present application, be understood as e.g. quantum wells, quantum dots, quantum rods, tripods, tetrapods, or nano-wires, etcetera. Organic phosphors can be used as well. Examples of suitable organic phosphor materials are organic luminescent materials based on perylene derivatives, for example compounds sold under the name Lumogen® by BASF. Examples of suitable compounds include, but are not limited to, Lumogen® Red F305, Lumogen® Orange F240, Lumogen® Yellow F083, and Lumogen® F170.

Different luminescent materials may have different spectral power distributions of the respective luminescent material light. Alternatively or additionally, such different luminescent materials may especially have different color points (or dominant wavelengths).

As indicated above, other luminescent materials may also be possible. Hence, in specific embodiments the luminescent material is selected from the group of divalent europium containing nitrides, divalent europium containing oxynitrides, divalent europium containing silicates, cerium comprising garnets, and quantum structures. Quantum structures may e.g. comprise quantum dots or quantum rods (or other quantum type particles) (see above). Quantum structures may also comprise quantum wells. Quantum structures may also comprise photonic crystals.

The luminescent material may be comprised by a luminescent body. The luminescent body may be a layer, like a self-supporting layer. The luminescent body may also be a coating. The luminescent body may also comprise a luminescent coating on a support (especially a light transmissive support in the transmissive mode). Especially, the luminescent body may essentially be self-supporting. In embodiments, the luminescent material may be provided as luminescent body, such as a luminescent single crystal, a luminescent glass, or a luminescent ceramic body. Such body may be indicated as "converter body" or "luminescent body". In embodiments, the luminescent body may be a luminescent single crystal or a luminescent ceramic body. For instance, in embodiments a cerium comprising garnet luminescent material may be provided as a luminescent single crystal or as a luminescent ceramic body. In other embodiments, the luminescent body may comprise a light transmissive body, wherein the luminescent material is embedded. For instance, the luminescent body may comprise a glass body, with luminescent material embedded therein. Or, the glass as such may be luminescent. In other embodiments, the luminescent body may comprise a polymeric body, with luminescent material embedded therein.

The luminescent material may not convert all light incident on the luminescent material, rather some of the light may be transmitted. The transmitted light may thus not be converted and hence, at least a part of the light incident on the luminescent material may be transmitted at the same wavelength of the incident light. In embodiments, the light generating devices and the luminescent material may be configured such that at least part of the second device light and/or at least part of the third device light is transmitted by the luminescent material. Therefore, light comprising a plurality of wavelengths may be outcoupled from the light generating system. Especially, the system light may comprise device light (transmitted by the luminescent material), and luminescent material light (due to conversion of the device light by the luminescent material). Hence, the spectral power distribution of the system light may be selected by combining the different aforementioned wavelengths.

Especially, in embodiments the light generating devices and the luminescent material may be configured such that at least part of first device light is transmitted by the luminescent material and at least part of first device light is converted by the luminescent material into luminescent material light.

As mentioned before, the luminescent material may have a relatively high excitation intensity at certain wavelengths i.e. specific wavelengths of light incident on the luminescent material may undergo a conversion to luminescent material light of a different wavelength. Hence, as mentioned before, the device light and the luminescent material may be selected such that the peak wavelength of the device light is equal to the wavelength for which the luminescent material has a high excitation intensity. Especially, the luminescent material may have a (relatively) highest excitation intensity for the first device light. Hence, in embodiments, at least one set of light generating devices (such as the first light generating devices) which may have a peak wavelength substantially equal to the wavelength at which the luminescent material may have the highest excitation intensity.

The system light may comprise a combination of transmitted and converted light (i.e. device light and luminescent material light).

In specific embodiments, at least 50% of the spectral power of the system light may be luminescent material light. This may be particularly beneficial for illumination purposes. Therefore, in embodiments, the first light generating devices may be the majority of the light generating devices comprised by the light generating system. However, in other embodiments the percentage of radiation in the UV-violet wavelength range and the percentage of the radiation in the visible wavelength range may be controllable.

However, in addition to the first light generating system, it may (also) be necessary to have a set of light generating devices that provide light that is transmitted (rather than converted), for example it is advantageous for disinfection purposes if UV-light is (at least partly) transmitted rather than (fully) converted. Hence, in embodiments, the plurality of sets of light generating devices may comprise a set of light generating devices with a peak wavelength for which the luminescent material has a very low excitation intensity. This is discussed in more detail further below.

The light generating system may comprise a plurality of sets of light generating devices. Especially, the number of light generating devices in the sets may not necessarily be equal, for example, the light generating system may comprise a majority of the light generating devices of the first set (i.e. they generate first device light).

As mentioned before, the light generating system may, especially, comprise light generating devices configured in an array. **In** embodiments, the distribution of the light generating devices in the array may not necessarily be symmetric. Especially, the array may comprise a 2D distribution of light generating devices, wherein the central regions of the array may be referred to as the core of the array and the regions surrounding the central core may be referred to as the periphery of the array. The number of light generating devices in the core and the peripheral part of the array may vary (see below). The shape of the array may (also) vary in embodiments. Especially, the array may have a circular, or rectangular, or square, or pentagonal, or hexagonal arrangement of light generating devices. Especially, in embodiments, the distribution of the light generating devices in the array may essentially be symmetric.

Hence, in embodiments, the array may comprise a core array part including x1% of a total number of the light generating devices and a peripheral array part including x2 % of the total number of the light generating devices. Further, a majority of the light generating devices for which peak wavelength of their device light the luminescent material has a relatively lower excitation intensity may be configured in the peripheral array part. This may, in embodiments, be the second light generating devices, or third light generating devices, or the $n^{th}$ light generating devices. However, in embodiments, the peripheral array part may (also) comprise the first light generating devices.

Further, in embodiments, a majority of the light generating devices for which peak wavelength of their device light the luminescent material has a relatively higher excitation intensity may be configured in the core array part. This may, in embodiments, be the first light generating devices. Additionally, in embodiments, the second light generating devices, or third light generating devices, or the $n^{th}$ light generating devices may (also) be configured in the core array part. Especially, x1% may be selected from the range of 5-95%, such as 10-90%, especially 15-85%. More especially, x2% may be selected from the range of 5-95%, such as 10-90%, especially 15-85%. In specific embodiments, x1% may be selected from the range of 20-80%, such as 25-75%. Especially, x2% may be selected from the range of 20-80%, especially 25-75%. Especially, x1%+x2%=100%.

In embodiments, x1% may be selected from the range 50-95%. Furthermore, in embodiments, x2% may be selected from the range 5-50%. Hence, embodiments of the light generating system may have at least half the total number of light generating devices (with a peak wavelength for which the luminescent material has a high excitation intensity) configured in the core array part. Further, not more than half the total number of light generating devices (with a peak wavelength for which the luminescent material has a low excitation intensity) may be configured in the peripheral array part.

In embodiments, at least 20% of the light generating devices may be first light generating devices. Yet, in embodiments at least 10% of the light generating devices may be second light generating devices. Yet, also in embodiments at least 10% of the light generating devices may be third light generating devices. In embodiments, at least 60% of the light generating devices may be defined by the first light generating devices, the second light generating devices, and the third light generating devices.

The array comprised an edge array part comprising one or more rows. The edge array part may also be referred to as "edge array region" (or "end region"). The edge array part comprises the majority of the light generating devices for which peak wavelength of their device light the luminescent material has the relatively lowest excitation intensity. The set of light generating devices (for example light generating devices with a peak wavelength in UV-light range) may, in embodiments, be used for disinfection. Hence, it may be advantageous that the device light from such light generating devices is transmitted (rather than converted). Hence, in embodiments, the majority of the light generating devices configured in the edge array part may comprise the set of light generating devices other the first light generating devices.

As mentioned before, the array may be a 1D or a 2D array of light generating devices. The edge array part in a 1D array may refer to the one or more light generating devices at the edge (or end) of the array of light generating devices, and the edge array part in a 2D array may refer to one or more rows of light generating devices at the edge of the array i.e. one or more rows of light generating devices may be the outermost rows of the array enclosing the remaining light generating devices. Especially, the light generating devices at the edge array part may have a peak wavelength for which the luminescent material has the lowest excitation intensity. Hence, the device light from the one or more light generating devices in the edge array part of the array may not undergo conversion to light of high intensity. Therefore, the device light from the majority of light generating devices at the edge array part may be transmitted as opposed to converted. This may be particularly advantageous for disinfection purposes, for example the system light may comprise unconverted UV light (from the light generating devices configured at the edge array part).

Further, in embodiments, the plurality of sets of light generating devices may comprise at least n sets of light generating devices. Especially, the plurality of sets of light generating devices may comprise at least three sets, such as at least four sets, and in specific embodiments at least five sets of light generating devices.

Hence, the light generating devices, in embodiments, may comprise a fourth set of fourth light generating devices configured to generate fourth device light having a fourth peak wavelength ($\lambda 4$) in the UV wavelength range, or violet wavelength range, or visible wavelength range. In embodiments, the light generating devices of the at least n sets may be configured according to increasing or decreasing excitation intensities of the luminescent material for the different excitation intensities at the different peak wavelengths. More in general, in embodiments, the system may comprise sets of $n^{th}$ light generating devices configured to generate $n^{th}$ device light having a $n^{th}$ peak wavelength ($\lambda n$) in the UV wavelength range, or violet wavelength range, or visible wavelength range, wherein n is 3, 4, or 5, and wherein n=4, there is also a $3^{rd}$ set, and when n=5, then there are also a $3^{rd}$ and $4^{th}$ set, etc. Hence, in embodiments the luminescent material may especially be configured to convert the first device light and in addition, at least a part of the second device light, and/or the third device light, and/or nth device light into luminescent material light.

Hence, in embodiments the luminescent material and the light generating devices may be configured such that the luminescent material is configured to convert at least part of the first device light into luminescent material light. Optionally, the luminescent material may also be configured to convert at least part of the device light of one or more of the $n^{th}$ type of light generating devices into luminescent material light. Further, when there is a plurality of types of light generating devices, there may be (though thus not necessarily) a set of light generating devices of which the device light may essentially not be converted by the luminescent materials. In such embodiments, at least part of the device light of such type of light generating devices may especially be transmitted by the luminescent material. In specific embodiments, the luminescent material may be configured to convert at least part of the second device light and/or at least part of the third device light into luminescent material light (and at least part of the first device light).

It is noted that the luminescent material may especially have a relatively high excitation intensity corresponding to specific peak wavelengths of the one or more light generating devices. However, for one or more other wavelengths, the luminescent material may have relatively lower excitation intensities. Or in other words, the oscillation strength may vary with wavelength. This may provide a (characteristic) excitation spectrum. Hence, when varying the emission wavelength of a light source, while maintaining its photon flux constant, the emission intensity of the luminescent material light will vary with excitation wavelength. Therefore, even would the first light generating device, the second light generating device, and optionally further light generating devices, like the third light generating devices, have equal photon fluxes, the radiant fluxes of the luminescent material light may differ for the different light generating devices. In embodiments, it may be desirable to select the radiant fluxes of the light generating devices such, that the radiant flux of the luminescent material light downstream of the luminescent material (downstream of the respective light generating devices) may essentially be the same. In this way, a radiant flux of the luminescent material light over 75-99 % of the luminescent material surface may (only) vary within a range of +/- 15% relative to an average radiant flux over the luminescent material surface, even more especially over at least 85%, such as at least 90% of the luminescent material surface. In specific embodiments a radiant flux of the luminescent material light over at least 95 % of the luminescent material surface may (only) vary within a range of +/- 15% relative to an average radiant flux over the luminescent material surface. The variation may even be a bit smaller, such as within about +/- 10%, such as within about +/-5%. For example, the luminescent material may have an increasing excitation intensity corresponding to the first device light, the second device light and the third device light (i.e. in an increasing order of excitation intensity from third to first device light).

However, the light generating system (in embodiments) may be configured such that intensity of the third device light may be higher than that of the second device light, which may (in turn) be higher than the first device light. As indicated above, this may result in that that the intensity of the luminescent material light by the respective first, second and third device light may essentially be the same intensity, though other configuration may also be chosen. Hence, alternative embodiments may also be possible. For instance, this may be relevant when one desire to focus more on the UV radiation related aspects instead of homogenous radiant flux. Especially when the peripheral array part is relatively small, the essentially even radiant flux of the luminescent material light may apply to the core array part, and not necessarily also to the peripheral array part.

Hence, in specific embodiments the photon flux of the device light may spatially vary over the luminescent material. Alternatively or additionally, in specific embodiments the excitation wavelength of the device light may spatially vary over the luminescent material.

In yet other embodiments, the light generating system may be configured such that photon fluxes of the (device light of the) light generating devices are essentially equal.

In alternative embodiments, the light generating system may be configured such that radiant fluxes of the (device light of the) light generating devices are essentially equal.

In yet alternative embodiments, the light generating system may be configured such that radiant fluxes of the (device light of the) light generating devices may decrease with increasing number of the indication of the respective type of light generating devices, i.e. the radiant flux of the (first device light of the) first light generating device is larger than of the radiant flux of the (second device light of the) second light generating device, which on its turn may be larger than the radiant flux of the (third device light of the) optional third light generating device, etc.

In embodiments, the conversion ratio of the luminescent material may thus show an increasing trend with increasing excitation wavelength, especially in the range of about 190-480 nm, such as 230-480 nm. Or, in embodiments the conversion ratio of the luminescent material may thus show a decreasing trend with decreasing excitation wavelength, especially in the range of about 480-190 nm, such as 480-230 nm.

Hence, in a cross-sectional view there may be at least an arrangement according to $E_{n5}D_{n4}C_{n3}B_{n2}A_{n1}B_{n2}C_{n3}D_{n4}E_{n5}$ arrangement, wherein A refers to light generating devices of a first type, like first light generating devices, and $n1 \geq 1$, and B refers to light generating devices of a second type, such as second light generating devices, wherein $n2 \geq 1$. In embodiments $n2 \geq 1$ and $n3 \geq 1$. Further, in embodiments, $n4 \geq 0$ and $n5 \geq 0$, such as $n4 > 0$ and $n5 \geq 0$. Further, in embodiments $n1 \geq n2+n3+n4+n5$.

Here, the excitation intensities may be arranged such that they may have an increasing or decreasing trend in wavelength of the device light from the plurality of sets of light generating devices. Further, in embodiments, the light generating devices and the luminescent material may be further configured such that at least part of the second (and/or third) device light is transmitted by the luminescent material. This may be particularly advantageous for disinfection purposes, for example the fourth device light may be selected from the wavelength range of UV light. Hence, in such an embodiment, the majority of UV light may be transmitted without a change in the wavelength of the UV light.

In embodiments, (i) at least one of the at least three different sets of light generating devices may be configured to generate radiation having a peak wavelength in a wavelength range selected from the group of UV-A radiation, UV-B radiation, and Near UV-C radiation, and (ii) at least another one of the at least three different sets of light generating devices may be configured to generate radiation having a peak wavelength in the violet wavelength range. With such an embodiment, a plurality of wavelengths may be provided i.e. the system light may comprise a plurality of wavelengths. Especially, the system light may comprise at least a peak wavelength from the group of UV-A radiation, UV-B radiation, and Near UV-C radiation. The majority of the device light comprising the aforementioned wavelengths may, in embodiments, be transmitted rather than converted (such as by the luminescent material). Further, in embodiments, the system light may comprise at least a peak wavelength in the violet wavelength range. Yet further, in such an embodiment, a part of the violet light may be converted and hence, the system light may also comprise white light. Therefore, in a specific embodiment, the system light may comprise transmitted light from the group of UV-A radiation, UV-B radiation, and Near UV-C radiation and (also) converted white light. Yet further, in embodiments, at least two of the at least three different sets of light generating devices may be configured to generate radiation having a peak wavelength in a wavelength range selected from the group of UV-A radiation, UV-B radiation, and Near UV-C radiation.

In specific embodiments, all light generating devices may be configured in series. This may be convenient in that the management of power to the light generating devices may be simple to configure. Alternatively, in embodiments, the light generating devices may be configured in parallel. The choice of the configuration of the light generating devices in series or parallel may be in dependence of the desired arrangement of light generating devices in the array.

In specific embodiments, two or more sets may be controlled individually. Especially, in this way, the composition of wavelengths comprised by the system light may be selected. Hence, in embodiments, two or more of the at least two sets of light generating devices may be individually controllable. More especially, in embodiments, three or more of the at least three sets of light generating devices may be individually controllable. Yet more especially, in embodiments, each of the sets may be controlled individually.

In embodiments, the light generating system may comprise a LED filament. Especially, an LED filament may be configured to provide LED filament light. The term "LED filament light" may refer to the light of the LED filament during operation of the LED filament. The LED filament may in embodiments comprises a plurality of light emitting diodes (LEDs), especially arranged in a linear array. The linear array may be a 1D or 2D array, of n*m LEDs, wherein n may in embodiments be selected from the range of 1-4, such as 1-3, like 1-2, such as in embodiments 1 or in embodiments 2, and m may be selected from the range of larger than n, such as especially selected from the range of at least 4 (when n<4), like at least 6, such as at least 8. Further, the LEDs may be arranged for emitting LED light e.g. of different colors or spectral power distributions. In embodiments, two or more LEDs may be configured to provide light having essentially the same spectral power distributions. Even more especially, in embodiments all LEDs may be configured to provide light having essentially the same spectral power distributions. In yet other embodiments, two or more LEDs may be configured to provide light having different spectral power distributions.

In embodiments, the LED filament may have a length L and a width W, with in specific embodiments L≥5W. The LED filament may be arranged in a straight configuration or in a non-straight configuration, such as for example a curved configuration, a (2D or 3D) spiral, or a helix.

In specific embodiments, the LEDs may be arranged on an (elongated) carrier like for instance a substrate. In embodiments, the (elongated) carrier may be rigid (made from e.g. a polymer, glass, quartz, metal or sapphire) or flexible (e.g. made of a polymer or metal e.g. a film or foil).

In case the carrier comprises a first major surface and an opposite second major surface, the LEDs are arranged on at least one of these surfaces. In embodiments, the carrier may be light reflective, especially reflective for the filament light. In embodiments, the carrier may be light transmissive, such as translucent and in specific embodiments transparent.

In embodiments, the LED filament may comprise an encapsulant at least partly covering at least part of the total number of LEDs (of the plurality of LEDs). In specific embodiments, the encapsulant may also at least partly cover at least one of the first major or second major surface.

The encapsulant may comprise a polymer material which may in embodiments be flexible such as for example a silicone. In embodiments, the encapsulant may comprise a resin.

In embodiments, the encapsulant may comprise one or more of a luminescent material and a light scattering material. Herein, especially the LED filament comprises at least the luminescent material. The one or more of the luminescent material and the light scattering material may be embedded in the encapsulant material, such as the polymer material. The luminescent material may especially be configured to at least partly convert LED light into converted light. The luminescent material may also be indicated as "phosphor". The luminescent material may comprise a phosphor such as an inorganic phosphor and/or quantum dots or rods.

Hence, the LED filament light may comprise in specific embodiments one or more of LED light and converted light ("luminescent material light").

In embodiments, the LED filament may comprise multiple sub-filaments.

As indicated above, the LED filament may in embodiments comprises a plurality of light emitting diodes. However, the term LED in the context of LED filament, may also refer to solid state light sources (in general). Hence, the LED filament may comprise one or more of LEDs, laser diodes, and superluminescent diodes. Especially, the LED filament comprises a plurality of light emitting diodes (LEDs).

Especially, the LED filament may comprise the array of light generating devices. More especially, at least the second light generating devices and the third light generating devices may be configured at one or both end parts of the LED filament. LED filaments may, in embodiments, comprise the plurality of sets of the light generating devices. Hence, the LED filament may, in embodiments, (also) provide system light. More especially, in embodiments the system light comprises LED filament light.

In embodiments, the light generating system may comprise a chip-on-board (or "COB") light generating device. Especially, the COB light generating device may comprise the array of light generating devices. Here, the array may be a 2D arrangement of light generating devices. Especially, the 2D array may comprise a core array part and a peripheral array part. More especially, the core array part may be in the center of the COB light generating device with the peripheral array part configured around and enclosing the core array part. Further, the light generating system may, in embodiments, further comprise a luminescent layer comprising the luminescent material. Hence, the COB light generating device may provide system light comprising a combination of luminescent material light and device light. Especially, the luminescent material may be configured downstream of the chip-on-board light generating device. Here, downstream refers to elements configured further along the optical path of the light escaping the COB light generating device. As mentioned before, in embodiments, the peripheral array part may enclose the core array part. Especially, the first light generating devices may be configured in the core array part and wherein the other light generating devices may be configured in the peripheral array part. More especially, the core array part comprises a center, wherein with increasing distance from the center the excitation intensity may decrease. In embodiments, the luminescent layer may be deposited on the COB.

The COB light generating device may, in embodiments, comprise a majority of the light generating devices in the core array part configured around a center, with the remaining light generating devices configured in the periphery. Especially, the device light comprising a peak wavelength with a higher excitation intensity may be configured in the center, for example the first set of the plurality of sets of light generating devices may be configured at the center, this may be followed by the second set around the first set, and so on. Hence, in such an embodiment, device light at the center of the array may undergo conversion to luminescent material light of the highest excitation intensity, and device light at the periphery may be transmitted with minimal conversion (or undergo conversion at lowest excitation intensity). Hence, this may provide the advantage of providing system light which may comprise light of a plurality of wavelengths in addition to transmitted UV light. Thus, the light generating system may provide illumination as well as be used for disinfection simultaneously.

In embodiments, the luminescent material may have a luminescent material surface. Especially, a radiant flux of the luminescent material light over 75-99%, such as 85-99%, especially 95-99% of the luminescent material surface may vary within a range of +/-15% relative to an average radiant flux over the luminescent material surface. There may be minor variations in the radiant flux over the surface of the luminescent material. However, in embodiments, the arrangement of the light generating devices in the array may be such that variation of the radiant flux over the majority of the luminescent material surface may especially be within a range of +/- 25%, such as +/- 15%, especially +/- 10% relative to an average radiant flux over the luminescent material surface. Therefore, with such an embodiment, system light with a uniform radiant flux may be provided.

The light generating system may be part of or may be applied in e.g. office lighting systems, household application systems, shop lighting systems, home lighting systems, accent lighting systems, spot lighting systems, theater lighting systems, fiber-optics application systems, projection systems, self-lit display systems, pixelated display systems, segmented display systems, warning sign systems, medical lighting application systems, indicator sign systems, decorative lighting systems, portable systems, automotive applications, (outdoor) road lighting systems, urban lighting systems, green house lighting systems, horticulture lighting, digital projection, or LCD backlighting. The light generating system (or luminaire) may be part of or may be applied in e.g. optical communication systems or disinfection systems.

As indicated above, the lighting unit may be used as backlighting unit in an LCD display device. Hence, the invention also provides an LCD display device comprising the lighting unit as defined herein, configured as backlighting unit. The invention also provides in a further aspect a liquid crystal display device comprising a back lighting unit, wherein the back lighting unit comprises one or more light generating systems as defined herein.

The terms "upstream" and "downstream" relate to an arrangement of items or features relative to the propagation of the light from a light generating means (here the especially the light source), wherein relative to a first position within a beam of light from the light generating means, a second position in the beam of light closer to the light generating means is "upstream", and a third position within the beam of light further away from the light generating means is "downstream".

The term "white light", and similar terms, herein, is known to the person skilled in the art. It may especially relate to light having a correlated color temperature (CCT) between about 1800 K and 20000 K, such as between 2000 and 20000 K, especially 2700-20000 K, for general lighting especially in the range of about 2000-7000 K, such as in the range of 2700 K and 6500 K. In embodiments, e.g. for backlighting purposes, or for other purposes, the correlated color temperature (CCT) may especially be in the range of about 7000 K and 20000 K. Yet further, in embodiments the correlated color temperature (CCT) is especially within about 15 SDCM (standard deviation of color matching) from the BBL (black body locus), especially within about 10 SDCM from the BBL, even more especially within about 5 SDCM from the BBL. In specific embodiments, the correlated color temperature (CCT) may be selected from the range of 6000-12000 K, like selected from the range of 7000-12000 K, like at least 8000 K. Yet further, in embodiments the correlated color temperature (CCT) may be selected from the range of 6000-12000 K, like selected from the range of 7000-12000 K, in combination with a CRI of at least 70.

In embodiments, the system light may be white light having a correlated color temperature in a range from 1800 to 6500 K. Here, the correlated color temperature (CCT) is a measure of light source color appearance defined by the proximity of the light source's chromaticity coordinates to the blackbody locus, as a single number rather than the two required to specify a chromaticity. Further, in embodiments, the system light may have a color rendering index of at least 80, such as at least 85, especially at least 90. A color rendering index (CRI) is a quantitative measure of the ability of a light source to reveal the colors of various objects faithfully in comparison with a natural or standard light source. The CRI is determined by the light source's spectrum. The value often quoted as "CRI" on commercially available lighting products is properly called the CIE Ra value, "CRI" being a general term and CIE Ra being the international standard color rendering index. Numerically, the highest possible CIE Ra value is 100 and would only be given to a source whose spectrum is identical to the spectrum of daylight, very close to that of a black body (incandescent lamps are effectively black bodies), dropping to negative values for some light sources.

The terms "visible", "visible light" or "visible emission" and similar terms refer to light having one or more wavelengths in the range of about 380-780 nm. Herein, UV may especially refer to a wavelength selected from the range of 190-380 nm, such as 200-380 nm. The term UV radiation may in specific embodiments refer to near UV radiation (NUV). Therefore, herein also the term "(N)UV" is applied, to refer to in general UV, and in specific embodiments to NUV. The term IR radiation may in specific embodiments refer to near IR radiation (NIR). Therefore, herein also the term "(N)IR" is applied, to refer to in general IR, and in specific embodiments to NIR. Herein, IR (infrared) may especially refer to radiation having a wavelength selected from the range of 780-3000 nm, such as 780-2000 nm, e.g. a wavelength up to about 1500 nm, like a wavelength of at least 900 nm, though in specific embodiments other wavelengths may also be possible. Hence, the term IR may herein refer to one or more of near infrared (NIR (or IR-A)) and short-wavelength infrared (SWIR (or IR-B)), especially NIR.

In embodiments, the light generating system may comprise a control system. Especially, the control system may be configured to control (or operate in a mode of operation), the one or more sets of light generating devices.

The term "controlling" and similar terms especially refer at least to determining the behavior or supervising the running of an element. Hence, herein "controlling" and similar terms may e.g. refer to imposing behavior to the element (determining the behavior or supervising the running of an element), etc., such as e.g. measuring, displaying, actuating, opening, shifting, changing temperature, etc.. Beyond that, the term "controlling" and similar terms may additionally include monitoring. Hence, the term "controlling" and similar terms may include imposing behavior on an element and also imposing behavior on an element and monitoring the element. The controlling of the element can be done with a control system, which may also be indicated as "controller". The control system and the element may thus at least temporarily, or permanently, functionally be coupled. The element may comprise the control system. In embodiments, the control system and element may not be physically coupled. Control can be done via wired and/or wireless control. The term "control system" may also refer to a plurality of different control systems, which especially are functionally coupled, and of which e.g. one control system may be a master control system and one or more others may be slave control systems. A control system may comprise or may be functionally coupled to a user interface.

The control system may also be configured to receive and execute instructions from a remote control. In embodiments, the control system may be controlled via an App on a device, such as a portable device, like a Smartphone or I-phone, a tablet, etc.. The device is thus not necessarily coupled to the lighting system, but may be (temporarily) functionally coupled to the lighting system.

Hence, in embodiments the control system may (also) be configured to be controlled by an App on a remote device. In such embodiments the control system of the lighting system may be a slave control system or control in a slave mode. For instance, the lighting system may be identifiable with a code, especially a unique code for the respective lighting system. The control system of the lighting system may be configured to be controlled by an external control system which has access to the lighting system on the basis of knowledge (input by a user interface of with an optical sensor (e.g. QR code reader) of the (unique) code. The lighting system may also comprise means for communicating with other systems or devices, such as on the basis of Bluetooth, Thread, WIFI, LiFi, ZigBee, BLE or WiMAX, or another wireless technology.

The system, or apparatus, or device may execute an action in a "mode" or "operation mode" or "mode of operation" or "operational mode". The term "operational mode may also be indicated as "controlling mode". Likewise, in a method an action or stage, or step may be executed in a "mode" or "operation mode" or "mode of operation" or "operational mode". This does not exclude that the system, or apparatus, or device may also be adapted for providing another controlling mode, or a plurality of other controlling modes. Likewise, this may not exclude that before executing the mode and/or after executing the mode one or more other modes may be executed.

However, in embodiments a control system may be available, that is adapted to provide at least the controlling mode. Would other modes be available, the choice of such modes may especially be executed via a user interface, though other options, like executing a mode in dependence of a sensor signal or a (time) scheme, may also be possible. The operation mode may in embodiments also refer to a system, or apparatus, or device, that can only operate in a single operation mode (i.e. "on", without further tunability).

Hence, in embodiments, the control system may control in dependence of one or more of an input signal of a user interface, a sensor signal (of a sensor), and a timer. The term "timer" may refer to a clock and/or a predetermined time scheme.

In yet a further aspect, the invention also provides a lamp or a luminaire comprising the light generating system as defined herein. The luminaire may further comprise a housing, optical elements, louvres, etc. etc... The lamp or luminaire may further comprise a housing enclosing the light generating system. The lamp or luminaire may comprise a light window in the housing or a housing opening, through which the system light may escape from the housing. In yet a further aspect, the invention also provides a projection device comprising the light generating system as defined herein. Especially, a projection device or "projector" or "image projector" may be an optical device that projects an image (or moving images) onto a surface, such as e.g. a projection screen. The projection device may include one or more light generating systems such as described herein. Hence, in an aspect the invention also provides a light generating device selected from the group of a lamp, a luminaire, a projector device, a disinfection device, a photochemical reactor, and an optical wireless communication device, comprising the light generating system as defined herein. The light generating device may comprise a housing or a carrier, configured to house or support, one or more elements of the light generating system.

BRIEF DESCRIPTION OF THE DRAWINGS

Embodiments of the invention will now be described, by way of example only, with reference to the accompanying schematic drawings in which corresponding reference symbols indicate corresponding parts, and in which:

Fig. 1 schematically depicts the top and cross-sectional view of an embodiment of the light generating system. The figure (also) depicts the distribution of the wavelengths corresponding to the first second and third device light.
Fig. 2 schematically depicts the excitation spectra of the luminescent material.
Fig. 3 schematically depicts an embodiment of a LED filament.
Fig. 4 schematically depicts an embodiment of a luminaire 2 comprising the light generating system 1000.

The schematic drawings are not necessarily to scale.

DETAILED DESCRIPTION OF THE EMBODIMENTS

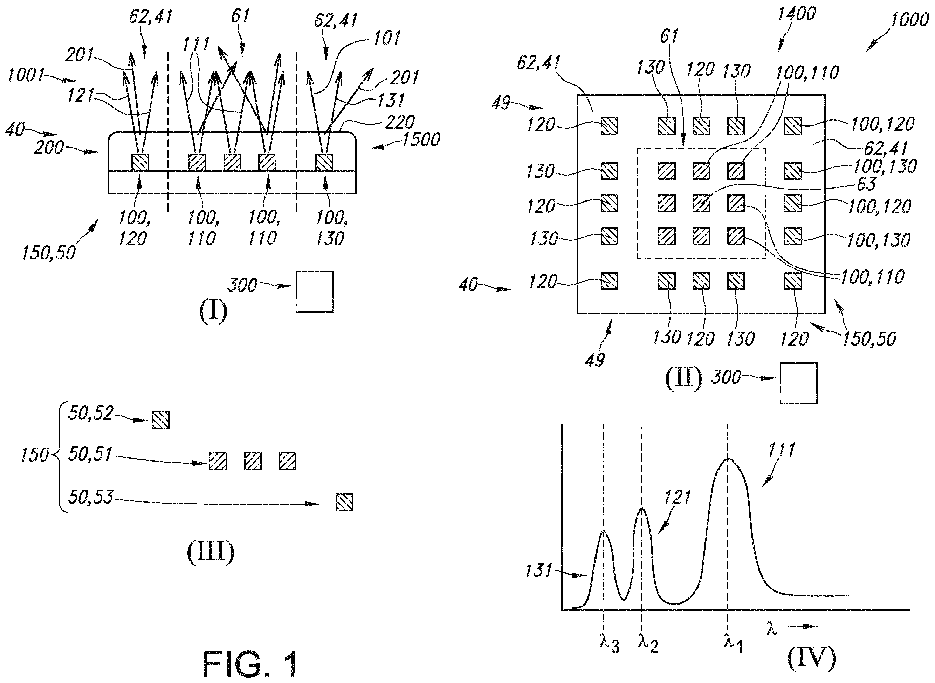

Fig. 1 schematically depicts the cross-sectional view (I) and top view (II) of an embodiment of the light generating system. Further, the figure depicts the plurality of sets of the one or more light generating devices (III). The figure (also) depicts the distribution of the wavelengths corresponding to the first, second and third device light (IV).

In embodiments, the invention may provide a light generating system 1000. Especially, the light generating system may comprise (a) a plurality of sets 150 of light generating devices 100 and (b) a luminescent material 200. The light generating devices 100 may be configured in an array 40. Further, the light generating devices 100 may be configured to generate device light 101. Especially, the light generating devices 100 may comprise solid state light sources. Further, in embodiments, the plurality of sets 150 of light generating devices 100 may comprise at least three sets 50 of light generating devices 100. Especially, light generating devices 100 of different sets may mutually differ in peak wavelengths of the device light 101. Especially, a first set of first light generating devices 110 may be configured to provide first device light 111 having a first peak wavelength ($\lambda 1$) in the visible wavelength range, especially the blue wavelength range, a second set of second light generating devices 120 may be configured to generate second device light 121 having a second peak wavelength ($\lambda 2$) in the UV wavelength range or in the violet wavelength range, and a third set of third light generating devices 130 may be configured to generate third device light 131 having a third peak wavelength ($\lambda 3$) in the UV wavelength range or in the violet wavelength range.

In embodiments, the luminescent material 200 may be configured downstream of the array 40 of light generating devices 100. Especially, the luminescent material 200 may be configured to convert at least part of the first device light 101 into luminescent material light 201. Further, in embodiments, the luminescent material 200 may be configured to convert at least part of the second device light 121 and/or at least part of the third device light 131 into luminescent material light 201. More especially, the luminescent material 200 may have different excitation intensities at the different peak wavelengths ($\lambda 1, \lambda 2, \lambda 3$). The different excitation intensities of the luminescent material in a specific embodiment are shown in (IV). By way of example, the excitation maxima may be, in the order of decreasing excitation intensity, about 455 nm, about 340 nm, and about 225 nm.

Hence, as schematically depicted, $\lambda 1$ may e.g. be about 455 nm, $\lambda 2$ may e.g. be about 340 nm, and $\lambda 1$ may e.g. be about 225 nm. However, in an example, while keeping $\lambda 1$ and $\lambda 2$ essentially the same, $\lambda 3$ may e.g. also chosen to be about at the minimum between the maxima at about 225 nm and 340 nm, or between the maxima at about 340 nm and 455 nm. Other embodiments, however, may also be possible.

The conversion ratio of the luminescent material may show an increasing trend with increasing excitation wavelength, especially in the range of about 190-480 nm, such as 230-480 nm.

In embodiments, the light generating devices 100 of the at least three sets 50 are configured according to increasing or decreasing excitation intensities of the luminescent material 200 for the different excitation intensities at the different peak wavelengths.

In embodiments, the light generating devices 100 and the luminescent material 200 may be configured such that at least part of the second device light 121 and/or at least part of the third device light 131 is transmitted by the luminescent material 200. Especially, the light generating devices 100 and the luminescent material 200 may be configured such that at least part of first device light 111 may be transmitted by the luminescent material 200 and at least part of first device light 111 may be converted by the luminescent material 200 into luminescent material light 201.

In embodiments, the array 40 may comprise a core array part 61 including x1% of a total number of the light generating devices 100 and a peripheral array part 62 including x2 % of the total number of the light generating devices 100. An embodiment of such is shown in (II). Especially, a majority of the light generating devices 100 for which peak wavelength of their device light 101 the luminescent material 200 has a relatively lower excitation intensity may be configured in the peripheral array part 62, and wherein a majority of the light generating devices 100 for which peak wavelength of their device light 101 the luminescent material 200 may have a relatively higher excitation intensity are configured in the core array part 61. Especially, x1% may be selected from the range of 5-95% and wherein x2% may be selected from the range of 5-95%. Especially, x1%+x2%=100%.

In embodiments, the luminescent material 200 may have a luminescent material surface 220. Especially, a radiant flux of the luminescent material light 201 over 75-99 % of the luminescent material surface 220 may vary within a range of +/- 15% relative to an average radiant flux over the luminescent material surface 220.

In embodiments, the array 40 may comprise an edge array part 41 comprising one or more rows 49. Especially, the edge array part 41 may comprise the majority of the light generating devices 100 for which peak wavelength of their device light 101 the luminescent material 200 has a relatively lowest excitation intensity.

The light generating system 1000, in embodiments, may comprise a chip-on-board light generating device 1400 comprising the array 40 of light generating devices 100 as shown in (II). Especially, the light generating system 1000 may further comprise a luminescent layer 1500 comprising the luminescent material 200 configured downstream of the chip-on-board light generating device 1400. Especially, the peripheral array part 62 may enclose the core array part 61. Further, the first light generating devices 110, in embodiments, may be configured in the core array part 61 and wherein the other light generating devices 120,130 may be configured in the peripheral array part 62. Especially, the core array part 61 may comprise a center 63, which with increasing distance of the center 63 the excitation intensity decreases. In embodiments, x1% may be selected from the range of 20-80%, and especially, x2% may be selected from the range of 20-80%.

Referring to e.g. embodiments I and II, the excitation wavelength of the device light (101) may thus spatially vary over the luminescent material 200.

In embodiments, (i) at least one of the at least three different sets 50 of light generating devices 100 may be configured to generate radiation having a peak wavelength in a wavelength range selected from the group of UV-A radiation, UV-B radiation, and Near UV-C radiation, and (ii) at least another one of the at least three different sets 50 of light generating devices 100 may be configured to generate radiation having a peak wavelength in the violet wavelength range. Further, in embodiments, at least two of the at least three different sets 50 of light generating devices 100 may be configured to generate radiation having a peak wavelength in a wavelength range selected from the group of UV-A radiation, UV-B radiation, and Near UV-C radiation.

In embodiments, the luminescent material 200 may comprise a luminescent material of the type $A_3B_5O_{12}$:Ce, wherein A comprises one or more of Y, La, Gd, Tb and Lu, and wherein B comprises one or more of Al, Ga, In and Sc. Further, in embodiments, the system light may be white light having a correlated color temperature in a range from 1800 to 6500 K and a color rendering index of at least 80.

In embodiments, all light generating devices 100 may be configured in series. Especially, two or more of the at least two sets 50 of light generating devices 100 may be individually controllable.

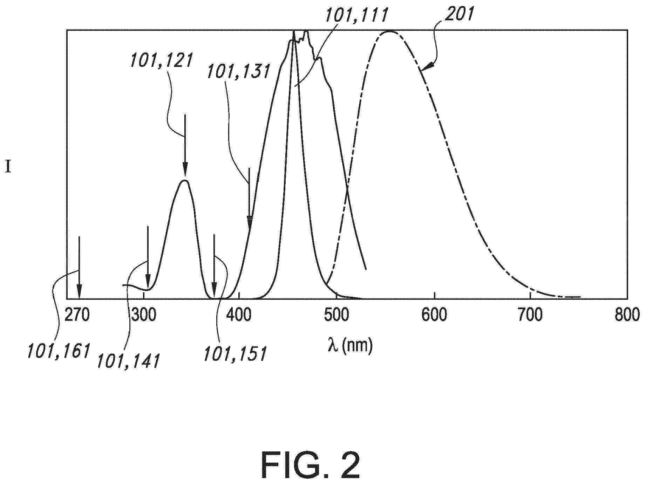

Fig. 2 schematically depicts the excitation spectra of the luminescent material. In embodiments, the luminescent material 200 may have a relatively highest excitation intensity for the first device light 111. Especially, the luminescent material 200 may be configured to convert at least part of the device light 101 into luminescent material light 201. More especially, the luminescent material 200 may have different excitation intensities at the different peak wavelengths. Especially, the light generating devices 100 of the at least three sets 50 may be configured according to increasing or decreasing excitation intensities of the luminescent material 200 for the different excitation intensities at the different peak wavelengths. In this figure, the solid lines depict the excitation spectra i.e. the wavelength of the incident device light 101 for which there is a corresponding emission spectra of luminescent material light 201 (of a different wavelength). In a specific embodiment, the highest intensity of the converted light may correspond to the first device light 111, while the other wavelengths such as the second device light 121 and the third device light 131 may have the lowest excitation intensity.

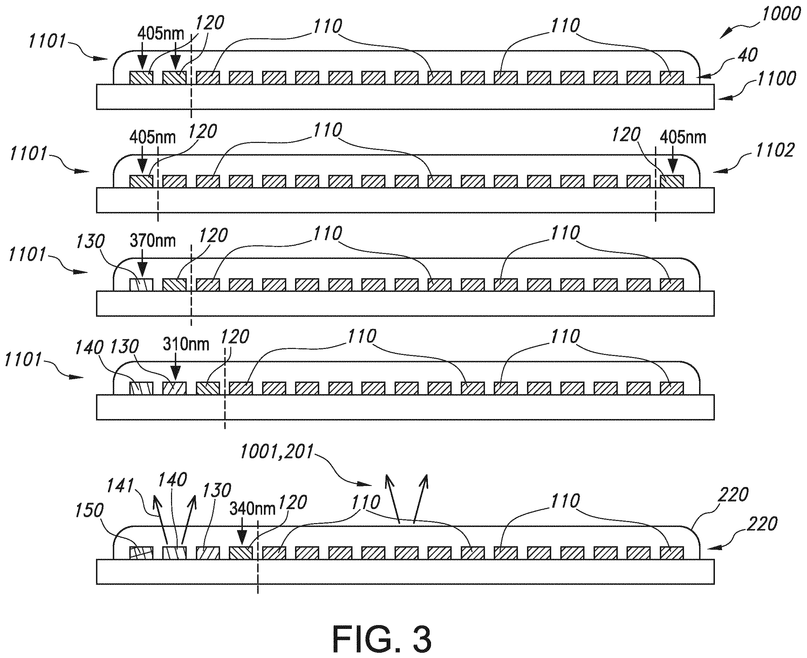

Fig. 3 schematically depicts several embodiments of the LED filament 1100. The light generating system 1000, in embodiments, may comprise a LED filament 1100. Especially, the LED filament 1100 may comprise the array 40 of light generating devices 100. In embodiments, the LED filament 1100 may comprise the first light generating device 110, or the second light generating device 120, or the third light generating device 130, or the fourth light generating device 140, or a combination thereof. Especially, at least the second light generating devices 120 and the third light generating devices 130 may be configured at one or both end parts 1101,1102 of the LED filament 1100. Further, in embodiments, the plurality of sets 150 of light generating devices 100 may comprise at least n sets 50 of light generating devices 100. Especially n=4, wherein the light generating devices 100 comprise a fourth set of fourth light generating devices 140 configured to generate fourth device light 141 having a fourth peak wavelength ($\lambda$4) in the UV wavelength range, or violet wavelength range, or visible wavelength range.

In embodiments, the light generating devices 100 of the at least n sets 50 may be configured according to increasing or decreasing excitation intensities of the luminescent material 200 for the different excitation intensities at the different peak wavelengths.

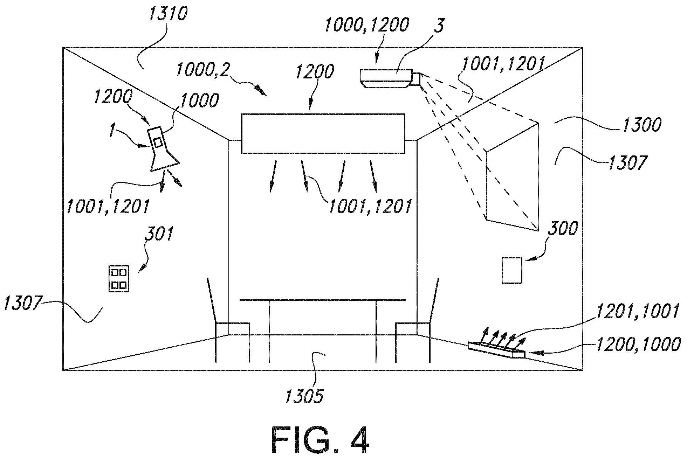

Fig. 4 schematically depicts an embodiment of a luminaire 2 comprising the light generating system 1000 as described above. Reference 301 indicates a user interface which may be functionally coupled with the control system 300 comprised by or functionally coupled to the light generating system 1000. Fig. 3 also schematically depicts an embodiment of lamp 1 comprising the light generating system 1000. Reference 3 indicates a projector device or projector system, which may be used to project images, such as at a wall, which may also comprise the light generating system 1000. Hence, Fig. 4 schematically depicts embodiments of a lighting device 1200 selected from the group of a lamp 1, a luminaire 2, a projector device 3, a disinfection device, a photochemical reactor, and an optical wireless communication device, comprising the light generating system 1000 as described herein. In embodiments, such lighting device may be a lamp 1, a luminaire 2, a projector device 3, a disinfection device, or an optical wireless communication device. Lighting device light escaping from the lighting device 1200 is indicated with reference 1201. Lighting device light 1201 may essentially consist of system light 1001, and may in specific embodiments thus be system light 1001. In embodiments, the light generating device 1200 may be configured provide system light 1001 on one or more surfaces in a room 1300. Especially, the light generating system 1000 may illuminate the walls 1307, or the floor 1305, or the ceiling 1310 in a room 1300.

The term "plurality" refers to two or more. The terms "substantially" or "essentially" herein, and similar terms, will be understood by the person skilled in the art. The terms "substantially" or "essentially" may also include embodiments with "entirely", "completely", "all", etc. Hence, in embodiments the adjective substantially or essentially may also be removed. Where applicable, the term "substantially" or the term "essentially" may also relate to 90% or higher, such as 95% or higher, especially 99% or higher, even more especially 99.5% or higher, including 100%. The term "comprise" also includes embodiments wherein the term "comprises" means "consists of". The term "and/or" especially relates to one or more of the items mentioned before and after "and/or". For instance, a phrase "item 1 and/or item 2" and similar phrases may relate to one or more of item 1 and item 2. The term "comprising" may in an embodiment refer to "consisting of" but may in another embodiment also refer to "containing at least the defined species and optionally one or more other species". Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein. Use of the verb "to comprise" and its conjugations does not exclude the presence of elements or steps other than those stated in a claim. Unless the context clearly requires otherwise, throughout the description and the claims, the words "comprise", "comprising", and the like are to be construed in an inclusive sense as opposed to an exclusive or exhaustive sense; that is to say, in the sense of "including, but not limited to". The article "a" or "an" preceding an element does not exclude the presence of a plurality of such elements.

The devices, apparatus, or systems may herein amongst others be described during operation. As will be clear to the person skilled in the art, the invention is not limited to methods of operation, or devices, apparatus, or systems in operation.

It should be noted that the above-mentioned embodiments illustrate rather than limit the invention, and that those skilled in the art will be able to design many alternative embodiments without departing from the scope of the invention as defined by the appended claims. In the claims, any reference signs placed between parentheses shall not be construed as limiting the claim.

The invention may be implemented by means of hardware comprising several distinct elements, and by means of a suitably programmed computer. In a device claim, or an apparatus claim, or a system claim, enumerating several means, several of these means may be embodied by one and the same item of hardware. The mere fact that certain measures are recited in mutually different dependent claims does not indicate that a combination of these measures cannot be used to advantage. In yet a further aspect, the invention (thus) provides a software product, which, when running on a computer is capable of bringing about (one or more embodiments of) the method as described herein. The invention also provides a control system that may control the device, apparatus, or system, or that may execute the herein described method or process. Yet further, the invention also provides a computer program product, when running on a computer which is functionally coupled to or comprised by the device, apparatus, or system, controls one or more controllable elements of such device, apparatus, or system. The invention further applies to a device, apparatus, or system comprising one or more of the characterizing features described in the description and/or shown in the attached drawings.

The various aspects discussed in this patent can be combined in order to provide additional advantages. Further, the person skilled in the art will understand that embodiments can be combined, and that also more than two embodiments can be combined.

## Claims

1. A light generating system (1000) comprising (a) a plurality of sets (150) of light generating devices (100) and (b) a luminescent material configured to generate visible light (200), wherein:

- the light generating devices (100) are configured in an array (40); wherein the light generating devices (100) are configured to generate device light (101); wherein the light generating devices (100) comprise solid state light sources;

- the plurality of sets (150) of light generating devices (100) comprises at least three sets (50) of light generating devices (100), wherein light generating devices (100) of different sets mutually differ in peak wavelengths of the device light (101), wherein a first set of first light generating devices (110) is configured to provide first device light (111) having a first peak wavelength ($\lambda 1$) in the blue wavelength range of 440-495 nm, a second set of second light generating devices (120) is configured to generate second device light (121) having a second peak wavelength ($\lambda 2$) in the UV wavelength range or in the violet wavelength range of 380-440 nm, and a third set of third light generating devices (130) is configured to generate third device light (131) having a third peak wavelength ($\lambda 3$) in the UV wavelength range or in the violet wavelength range of 380-440 nm;

- the luminescent material (200) is configured downstream of the array (40) of light generating devices (100); wherein the luminescent material (200) is configured to convert at least part of the first device light (101) into luminescent material light (201); and wherein the luminescent material (200) is configured to convert at least part of the second device light (121) and/or at least part of the third device light (131) into luminescent material light (201); wherein the luminescent material (200) has different excitation intensities at the different peak wavelengths ($\lambda 1$, $\lambda 2$, $\lambda 3$);

- the light generating devices (100) of the at least three sets (50) are configured in the array (40) according to increasing or decreasing excitation intensities of the luminescent material (200) for the different excitation intensities at the different peak wavelengths, taking into account the excitation spectrum of the luminescent material;

- wherein the array (40) comprises an edge array part (41) comprising one or more rows (49), wherein the edge array part (41) comprises the majority of the light generating devices (100) for which peak wavelength of their device light (101) the luminescent material (200) has a relatively lowest excitation intensity; and

- wherein the light generating devices (100) and the luminescent material (200) are configured such that at least part of the second device light (121) and/or at least part of the third device light (131) is transmitted by the luminescent material (200).

2. The light generating system (1000) according to claim 1, wherein the second set of second light generating devices (120) is configured to generate second device light (121) having a second peak wavelength ($\lambda 2$) in the violet wavelength range of 380-440 nm, and the third set of third light generating devices (130) is configured to generate third device light (131) having a third peak wavelength ($\lambda 3$) in the UV wavelength range.

3. The light generating system (1000) according to any one of the preceding claims, wherein the light generating devices (100) and the luminescent material (200) are configured such that at least part of first device light (111) is transmitted by the luminescent material (200).

4. The light generating system (1000) according to any one of the preceding claims, wherein the luminescent material (200) has a relatively highest excitation intensity for the first device light (111).

5. The light generating system (1000) according to any one of the preceding claims, wherein the array (40) comprises a core array part (61) including x1% of a total number of the light generating devices (100) and a peripheral array part (62) including x2 % of the total number of the light generating devices (100), wherein a majority of the light generating devices (100) for which peak wavelength of their device light (101) the luminescent material (200) has a relatively lower excitation intensity are configured in the peripheral array part (62), and wherein a majority of the light generating devices (100) for which peak wavelength of their device light (101) the luminescent material (200) has a relatively higher excitation intensity are configured in the core array part (61); wherein x1% is selected from the range of 5-95%, wherein x2% is selected from the range of 5-95%, and wherein x1%+x2%=100%.

6. The light generating system (1000) according to any one of the preceding claims, wherein two sets of light generating devices, such as in a symmetrical arrangement, like concentric, or a linear $C_{n3}B_{n2}A_{n1}B_{n2}C_{n3}$ arrangement, wherein A refers to light generating devices of a first type, like first light generating devices, and $n1 \geq 1$, B refers to light generating devices of a second type, such as second light generating devices, wherein $n2 \geq 1$, C refers to light generating devices of a third type, such as third light generating devices, wherein $n3 \geq 1$, and wherein in embodiments $n1 > n2 > n3$.

7. The light generating system (1000) according to any one of the preceding claims, wherein:

- the plurality of sets (150) of light generating devices (100) comprises at least n sets (50) of light generating devices (100), wherein n=4, wherein the light generating devices (100) comprise a fourth set of fourth light generating devices (140) configured to generate fourth device light (141) having a fourth peak wavelength ($\lambda 4$) in the UV wavelength range, or violet wavelength range, or visible wavelength range;

- the light generating devices (100) of the at least n sets (50) are configured according to increasing or decreasing excitation intensities of the luminescent material (200) for the different excitation intensities at the different peak wavelengths.

8. The light generating system (1000) according to any one of the preceding claims, wherein (i) at least one of the at least three different sets (50) of light generating devices (100) is configured to generate radiation having a peak wavelength in a wavelength range selected from the group of UV-A radiation, UV-B radiation, and Near UV-C radiation, and (ii) at least another one of the at least three different sets (50) of light generating devices (100) is configured to generate radiation having a peak wavelength in the violet wavelength range of 380-440 nm.

9. The light generating system (1000) according to any one of the preceding claims, wherein the luminescent material (200) comprises a luminescent material of the type $A_3B_5O_{12}$:Ce, wherein A comprises one or more of Y, La, Gd, Tb and Lu, and wherein B comprises one or more of Al, Ga, In and Sc; and wherein the system light is white light having a correlated color temperature in a range from 1800 to 6500 K and a color rendering index of at least 80.

10. The light generating system (1000) according to any one of the preceding claims 1-9, wherein all light generating devices (100) are configured in series.

11. The light generating system (1000) according to any one of the preceding claims 1-9, wherein two or more of the at least two sets (50) of light generating devices (100) are individually controllable.

12. The light generating system (1000) according to any one of the preceding claims, comprising a LED filament (1100), wherein the LED filament (1100) comprises the array (40) of light generating devices (100): wherein at least the second light generating devices (120) and the third light generating devices (130) are configured at one or both end parts (1101,1102) of the LED filament (1100).

13. The light generating system (1000) according to any one of the preceding claims, comprising a chip-on-board light generating device (1400) comprising the array (40) of light generating devices (100); wherein the light generating system (1000) further comprises a luminescent layer (1500) comprising the luminescent material (200) configured downstream of the chip-on-board light generating device (1400); wherein the peripheral array part (62) encloses the core array part (61); wherein the first light generating devices (110) are configured in the core array part (61) and wherein the other light generating devices (120,130,140) are configured in the peripheral array part (62), wherein the core array part (61) comprises a center (63), wherein with increasing distance of the center (63) the excitation intensity decreases; and wherein x1% is selected from the range of 20-80%, and wherein x2% is selected from the range of 20-80%, wherein x1 and x2 are as defined in claim 5.

14. The light generating system (1000) according to any one of the preceding claims, wherein the luminescent material (200) has a luminescent material surface (220), wherein a radiant flux of the luminescent material light (201) over 75-99 % of the luminescent material surface (220) varies within a range of +/- 15% relative to an average radiant flux over the luminescent material surface (220).

15. A lighting device (1200) selected from the group of a lamp (1), a luminaire (2), and an optical wireless communication device, comprising the light generating system (1000) according to any one of the preceding claims.

**Patentansprüche**

1. Lichterzeugungssystem (1000), umfassend (a) eine Vielzahl von Sätzen (150) von Lichterzeugungsvorrichtungen (100) und (b) einen Leuchtstoff, der konfiguriert ist, um sichtbares Licht (200) zu erzeugen, wobei:

- die Lichterzeugungsvorrichtungen (100) in einer Anordnung (40) konfiguriert sind; wobei die Lichterzeugungsvorrichtungen (100) konfiguriert sind, um Vorrichtungslicht (101) zu erzeugen; wobei die Lichterzeugungsvorrichtungen (100) eine Festkörperlichtquelle umfassen;
- die Vielzahl von Sätzen (150) von Lichterzeugungsvorrichtungen (100) mindestens drei Sätze (50) von Lichterzeugungsvorrichtungen (100) umfasst, wobei Lichterzeugungsvorrichtungen (100) unterschiedliche Sätze von sich gegenseitig in Spitzenwellenlängen des Vorrichtungslichts (101) unterscheiden, wobei ein erster Satz von ersten Lichterzeugungsvorrichtungen (110) konfiguriert ist, um erstes Vorrichtungslicht (111), das eine erste Spitzenwellenlänge (λ1) in dem blauen Wellenlängenbereich von 440-495 nm aufweist, bereitzustellen, ein zweiter Satz von zweiten Lichterzeugungsvorrichtungen (120) konfiguriert ist, um zweites Vorrichtungslicht (121), das eine zweite Spitzenwellenlänge (λ2) in dem UV-Wellenlängenbereich oder in dem violetten Wellenlängenbereich von 380-440 nm aufweist, zu erzeugen, und ein dritter Satz von dritten Lichterzeugungsvorrichtungen (130) konfiguriert ist, um drittes Vorrichtungslicht (131), das eine dritte Spitzenwellenlänge (λ3) in dem UV-Wellenlängenbereich oder in dem violetten Wellenlängenbereich von 380-440 nm aufweist, zu erzeugen;

- der Leuchtstoff (200) stromabwärts von der Anordnung (40) von Lichterzeugungsvorrichtungen (100) konfiguriert ist; wobei der Leuchtstoff (200) konfiguriert ist, um mindestens einen Teil des ersten Vorrichtungslichts (101) in Leuchtstofflicht (201) umzuwandeln; und wobei der Leuchtstoff (200) konfiguriert ist, um mindestens einen Teil des zweiten Vorrichtungslichts (121) und/oder mindestens einen Teil des dritten Vorrichtungslichts (131) in Leuchtstoff (201) umzuwandeln; wobei der Leuchtstoff (200) unterschiedliche Anregungsintensitäten bei den unterschiedlichen Spitzenwellenlängen (λ1, λ2, λ3) aufweist;

- die Lichterzeugungsvorrichtungen (100) der mindestens drei Sätze (50) in der Anordnung (40) gemäß zunehmenden oder abnehmenden Anregungsintensitäten des Leuchtstoffs (200) für die unterschiedlichen Anregungsintensitäten bei den unterschiedlichen Spitzenwellenlängen unter Berücksichtigung des Anregungsspektrums des Leuchtstoffs konfiguriert sind;

- wobei die Anordnung (40) einen Randanordnungsteil (41) umfasst, umfassend eine oder mehrere Reihen (49), wobei der Randanordnungsteil (41) die Mehrzahl der Lichterzeugungsvorrichtungen (100) umfasst, für deren Spitzenwellenlänge ihres Vorrichtungslichts (101) der Leuchtstoff (200) eine relativ niedrigste Anregungsintensität aufweist; und

- wobei die Lichterzeugungsvorrichtungen (100) und der Leuchtstoff (200) derart konfiguriert sind, dass mindestens ein Teil des zweiten Vorrichtungslichts (121) und/oder mindestens ein Teil des dritten Vorrichtungslichts (131) durch den Leuchtstoff (200) übertragen wird.

2. Lichterzeugungssystem (1000) nach Anspruch 1, wobei der zweite Satz von zweiten Lichterzeugungsvorrichtungen (120) konfiguriert ist, um zweites Vorrichtungslicht (121), das eine zweite Spitzenwellenlänge (λ2) in dem violetten Wellenlängenbereich von 380-440 nm aufweist, zu erzeugen, und der dritte Satz von dritten Lichterzeugungsvorrichtungen (130) konfiguriert ist, um drittes Vorrichtungslicht (131), das eine dritte Spitzenwellenlänge (λ3) in dem UV-Wellenlängenbereich aufweist, zu erzeugen.

3. Lichterzeugungssystem (1000) nach einem der vorstehenden Ansprüche, wobei die Lichterzeugungsvorrichtungen (100) und der Leuchtstoff (200) derart konfiguriert sind, dass mindestens ein Teil des ersten Vorrichtungslichts (111) durch den Leuchtstoff (200) übertragen wird.

4. Lichterzeugungssystem (1000) nach einem der vorstehenden Ansprüche, wobei der Leuchtstoff (200) eine relativ höchste Anregungsintensität für das erste Vorrichtungslicht (111) aufweist.

5. Lichterzeugungssystem (1000) nach einem der vorstehenden Ansprüche, wobei die Anordnung (40) einen Kernanordnungsteil (61) umfasst, der x1 % einer Gesamtanzahl der Lichterzeugungsvorrichtungen (100) einschließt, und einen peripheren Anordnungsteil (62), der x2 % der Gesamtanzahl der Lichterzeugungsvorrichtungen (100) einschließt, wobei eine Mehrzahl der Lichterzeugungsvorrichtungen (100), für deren Spitzenwellenlänge ihres Vorrichtungslichts (101) der Leuchtstoff (200) eine relativ geringere Anregungsintensität aufweist, in dem peripheren Anordnungsteil (62) konfiguriert ist, und wobei eine Mehrzahl der Lichterzeugungsvorrichtungen (100), für deren Spitzenwellenlänge ihres Vorrichtungslichts (101) der Leuchtstoff (200) eine relativ höhere Anregungsintensität aufweist, in dem Kernanordnungsteil (61) konfiguriert ist; wobei x1 % aus dem Bereich von 5-95 % ausgewählt ist, wobei x2 % aus dem Bereich von 5-95 % ausgewählt ist, und wobei

$$x1\ \%+x2\ \%=100\ \%.$$

6. Lichterzeugungssystem (1000) nach einem der vorstehenden Ansprüche, wobei zwei Sätze von Lichterzeugungsvorrichtungen, wie in einer symmetrischen Anordnung, wie konzentrisch, oder einer linearen $C_{n3}B_{n2}A_{n1}B_{n2}C_{n3}$ Anordnung, wobei A sich auf Lichterzeugungsvorrichtungen eines ersten Typs bezieht, wie erste Lichterzeugungsvorrichtungen, und $n1 \geq 1$, B sich auf Lichterzeugungsvorrichtungen eines zweiten Typs bezieht, wie zweite Lichterzeugungsvorrichtungen, wobei $n2 \geq 1$, C sich auf Lichterzeugungsvorrichtungen eines dritten Typs bezieht, wie dritte Lichterzeugungsvorrichtungen, wobei $n3 \geq 1$, und wobei in Ausführungsformen $n1>n2>n3$.

7. Lichterzeugungssystem (1000) nach einem der vorstehenden Ansprüche, wobei:

  - die Vielzahl von Sätzen (150) von Lichterzeugungsvorrichtungen (100) mindestens n Sätze (50) von Lichterzeugungsvorrichtungen (100) umfasst, wobei n=4, wobei die Lichterzeugungsvorrichtungen (100) einen vierten Satz von vierten Lichterzeugungsvorrichtungen (140) umfassen, die konfiguriert sind, um viertes Vorrichtungslicht (141), die eine vierte Spitzenwellenlänge ($\lambda4$) in dem UV-Wellenlängenbereich oder violetten Wellenlängenbereich oder sichtbaren Wellenlängenbereich aufweist, zu erzeugen;
  - die Lichterzeugungsvorrichtungen (100) der mindestens n Sätze (50) gemäß zunehmenden oder abnehmenden Anregungsintensitäten des Leuchtstoffs (200) für die unterschiedlichen Anregungsintensitäten bei den unterschiedlichen Spitzenwellenlängen konfiguriert.

8. Lichterzeugungssystem (1000) nach einem der vorstehenden Ansprüche, wobei (i) mindestens einer der mindestens drei unterschiedlichen Sätze (50) von Lichterzeugungsvorrichtungen (100) konfiguriert ist, um Strahlung zu erzeugen, die eine Spitzenwellenlänge in einem Wellenlängenbereich aufweist, der aus der Gruppe von UV-A-Strahlung, UV-B-Strahlung und Nah-UV-C-Strahlung ausgewählt ist, und (ii) mindestens ein anderer der mindestens drei unterschiedlichen Sätze (50) von Lichterzeugungsvorrichtungen (100) konfiguriert ist, um Strahlung zu erzeugen, die eine Spitzenwellenlänge in dem violetten Wellenlängenbereich von 380-440 nm aufweist.

9. Lichterzeugungssystem (1000) nach einem der vorstehenden Ansprüche, wobei der erste Leuchtstoff (200) einen Leuchtstoff des Typs $A_3B_5O_{12}$:Ce umfasst, wobei A eines oder mehrere von Y, La, Gd, Tb und Lu umfasst, und wobei B eines oder mehrere von Al, Ga, In und Sc umfasst; und wobei das Systemlicht weißes Licht ist, das eine korrelierte Farbtemperatur in einem Bereich von 1800 bis 6500 K und einen Farbwiedergabeindex von mindestens 80 aufweist.

10. Lichterzeugungssystem (1000) nach einem der vorstehenden Ansprüche 1 bis 9, wobei alle Lichterzeugungsvorrichtungen (100) in Reihe konfiguriert sind.

11. Lichterzeugungssystem (1000) nach einem der vorstehenden Ansprüche 1 bis 9, wobei zwei oder mehr der mindestens zwei Sätze (50) von Lichterzeugungsvorrichtungen (100) individuell steuerbar sind.

12. Lichterzeugungssystem (1000) nach einem der vorstehenden Ansprüche, umfassend ein LED-Filament (1100), wobei das LED-Filament (1100) die Anordnung (40) von Lichterzeugungsvorrichtungen (100) umfasst; wobei mindestens die zweiten Lichterzeugungsvorrichtungen (120) und die dritten Lichterzeugungsvorrichtungen (130) an einem oder beiden Endteilen (1101,1102) des LED-Filaments (1100) konfiguriert sind.

13. Lichterzeugungssystem (1000) nach einem der vorstehenden Ansprüche, umfassend eine Chip-on-Board-Lichterzeugungsvorrichtung (1400), umfassend die Anordnung (40) von Lichterzeugungsvorrichtungen (100); wobei das Lichterzeugungssystem (1000) ferner eine Leuchtstoffschicht (1500) umfasst, umfassend den Leuchtstoff (200), der stromabwärts von der Chip-on-Board-Lichterzeugungsvorrichtung (1400) konfiguriert ist; wobei der periphere Anordnungsteil (62) den Kernanordnungsteil (61) umschließt; wobei die ersten Lichterzeugungsvorrichtungen (110) in dem Kernanordnungsteil (61) konfiguriert sind und wobei die anderen Lichterzeugungsvorrichtungen (120,130,140) in dem peripheren Anordnungsteil (62) konfiguriert sind, wobei der Kernanordnungsteil (61) eine Mitte (63) umfasst, wobei mit zunehmendem Abstand von der Mitte (63) die Anregungsintensität abnimmt; und wobei x1 % aus dem Bereich von 20-80 % ausgewählt ist, und wobei x2 % aus dem Bereich von 20-80 % ausgewählt ist, wobei x1 und x2 wie in Anspruch 5 definiert sind.

14. Lichterzeugungssystem (1000) nach einem der vorstehenden Ansprüche, wobei der Leuchtstoff (200) eine Leuchtstoffoberfläche (220) aufweist, wobei ein Strahlungsfluss des Leuchtstofflicht (201) über 75-99 % der Leuchtstoffoberfläche (220) innerhalb eines Bereichs von +/- 15 % relativ zu einem durchschnittlichen Strahlungsfluss über die Leuchtstoffoberfläche (220) variiert.

15. Beleuchtungsvorrichtung (1200), ausgewählt aus der Gruppe einer Lampe (1), einer Leuchte (2) und einer optischen drahtlosen Kommunikationsvorrichtung, umfassend das Lichterzeugungssystem (1000) nach einem der vorstehenden Ansprüche.

**Revendications**

1. Système générateur de lumière (1000) comprenant (a) une pluralité d'ensembles (150) de dispositifs générateurs de lumière (100) et (b) un matériau luminescent configuré pour générer de la lumière visible (200), dans lequel :

- les dispositifs générateurs de lumière (100) sont configurés dans un réseau (40) ; dans lequel les dispositifs générateurs de lumière (100) sont configurés pour générer de la lumière de dispositif (101) ; dans lequel les dispositifs générateurs de lumière (100) comprennent des sources de lumière à semi-conducteurs ;
- la pluralité d'ensembles (150) de dispositifs générateurs de lumière (100) comprend au moins trois ensembles (50) de dispositifs générateurs de lumière (100), dans lequel les dispositifs générateurs de lumière (100) de différents ensembles diffèrent mutuellement dans les longueurs d'onde de pic de la lumière de dispositif (101), dans lequel un premier ensemble de premiers dispositifs générateurs de lumière (110) est configuré pour fournir de la lumière de premier dispositif (111) ayant une première longueur d'onde de pic ($\lambda 1$) dans la plage de longueur d'onde bleue de 440 à 495 nm, un deuxième ensemble de deuxièmes dispositifs générateurs de lumière (120) est configuré pour générer de la lumière de deuxième dispositif (121) ayant une deuxième longueur d'onde de pic ($\lambda 2$) dans la plage de longueur d'onde UV ou dans la plage de longueur d'onde violette de 380 à 440 nm, et un troisième ensemble de troisièmes dispositifs générateurs de lumière (130) est configuré pour générer de la lumière de troisième dispositif (131) ayant une troisième longueur d'onde de pic ($\lambda 3$) dans la plage de longueur d'onde UV ou dans la plage de longueur d'onde violette de 380 à 440 nm ;
- le matériau luminescent (200) est configuré en aval du réseau (40) de dispositifs générateurs de lumière (100) ; dans lequel le matériau luminescent (200) est configuré pour convertir au moins une partie de la lumière de premier dispositif (101) en lumière de matériau luminescent (201) ; et dans lequel le matériau luminescent (200) est configuré pour convertir au moins une partie de la lumière de deuxième dispositif (121) et/ou au moins une partie de la lumière de troisième dispositif (131) en lumière de matériau luminescent (201) ; dans lequel le matériau luminescent (200) a des intensités d'excitation différentes aux différentes longueurs d'onde de pic ($\lambda 1$, $\lambda 2$, $\lambda 3$) ;
- les dispositifs générateurs de lumière (100) des au moins trois ensembles (50) sont configurés dans le réseau (40) selon des intensités d'excitation croissantes ou décroissantes du matériau luminescent (200) pour les intensités d'excitation différentes aux différentes longueurs d'onde de pic, en tenant compte du spectre d'excitation du matériau luminescent ;
- dans lequel le réseau (40) comprend une partie de réseau de bord (41) comprenant une ou plusieurs rangées (49), dans lequel la partie de réseau de bord (41) comprend la majorité des dispositifs générateurs de lumière (100) pour la longueur d'onde de pic de leur lumière de dispositif (101) desquels le matériau luminescent (200) a une intensité d'excitation relativement la plus basse ; et
- dans lequel les dispositifs générateurs de lumière (100) et le matériau luminescent (200) sont configurés de sorte qu'au moins une partie de la lumière de deuxième dispositif (121) et/ou au moins une partie de la lumière de troisième dispositif (131) sont transmises par le matériau luminescent (200).

2. Système générateur de lumière (1000) selon la revendication 1, dans lequel le deuxième ensemble de deuxièmes dispositifs générateurs de lumière (120) est configuré pour générer de la lumière de deuxième dispositif (121) ayant une deuxième longueur d'onde de pic ($\lambda 2$) dans la plage de longueur d'onde violette de 380 à 440 nm, et le troisième ensemble de troisièmes dispositifs générateurs de lumière (130) est configuré pour générer de la lumière de troisième dispositif (131) ayant une troisième longueur d'onde de pic ($\lambda 3$) dans la plage de longueur d'onde UV.

3. Système générateur de lumière (1000) selon l'une quelconque des revendications précédentes, dans lequel les dispositifs générateurs de lumière (100) et le matériau luminescent (200) sont configurés de sorte qu'au moins une partie de la lumière de premier dispositif (111) est transmise par le matériau luminescent (200).

4. Système générateur de lumière (1000) selon l'une quelconque des revendications précédentes, dans lequel le matériau luminescent (200) a une intensité d'excitation relativement la plus élevée pour la lumière de premier dispositif (111).

5. Système générateur de lumière (1000) selon l'une quelconque des revendications précédentes, dans lequel le réseau (40) comprend une partie de réseau centrale (61) comportant x1 % d'un nombre total des dispositifs générateurs de lumière (100) et une partie de réseau périphérique (62) comportant x2 % du nombre total des dispositifs générateurs de lumière (100), dans lequel une majorité des dispositifs générateurs de lumière (100) pour la longueur d'onde de pic de leur lumière de dispositif (101) desquels le matériau luminescent (200) a une intensité d'excitation relativement plus basse sont configurés dans la partie de réseau périphérique (62), et dans lequel une majorité des dispositifs générateurs de lumière (100) pour la longueur d'onde de pic de leur lumière de dispositif (101) desquels le matériau luminescent (200) a une intensité d'excitation relativement plus élevée sont configurés dans la partie de réseau centrale (61) ; dans lequel x1 % est sélectionné dans la plage de 5 à 95 %, dans lequel x2 % est sélectionné dans la plage de 5 à 95 %, et
dans lequel

$$x1 \% + x2 \% = 100 \%.$$

6. Système générateur de lumière (1000) selon l'une quelconque des revendications précédentes, dans lequel deux ensembles de dispositifs générateurs de lumière, tels que dans un agencement symétrique, de type concentrique, ou un agencement linéaire $C_{n3}B_{n2}A_{n1}B_{n2}C_{n3}$, dans lequel A fait référence aux dispositifs générateurs de lumière d'un premier type, de type premiers dispositifs générateurs de lumière, et $n1 \geq 1$, B fait référence à des dispositifs générateurs de lumière d'un deuxième type, tels que les deuxièmes dispositifs générateurs de lumière, dans lequel $n2 \geq 1$, C fait référence à des dispositifs générateurs de lumière d'un troisième type, tels que les troisièmes dispositifs générateurs de lumière, dans lequel $n3 \geq 1$, et dans lequel dans des modes de réalisation $n1 > n2 > n3$.

7. Système générateur de lumière (1000) selon l'une quelconque des revendications précédentes, dans lequel :

- la pluralité d'ensembles (150) de dispositifs générateurs de lumière (100) comprend au moins n ensembles (50) de dispositifs générateurs de lumière (100), dans lequel n=4, dans lequel les dispositifs générateurs de lumière (100) comprennent un quatrième ensemble de quatrièmes dispositifs générateurs de lumière (140) configurés pour générer de la lumière de quatrième dispositif (141) ayant une quatrième longueur d'onde de pic ($\lambda$4) dans la plage de longueur d'onde UV, ou la plage de longueur d'onde violette, ou la plage de longueur d'onde visible ;
- les dispositifs générateurs de lumière (100) des au moins n ensembles (50) sont configurés selon des intensités d'excitation croissantes ou décroissantes du matériau luminescent (200) pour les intensités d'excitation différentes aux différentes longueurs d'onde de pic.

8. Système générateur de lumière (1000) selon l'une quelconque des revendications précédentes, dans lequel (i) au moins l'un parmi les au moins trois différents ensembles (50) de dispositifs générateurs de lumière (100) est configuré pour générer un rayonnement ayant une longueur d'onde de pic dans une plage de longueur d'onde sélectionnée dans le groupe de rayonnement UV-A, rayonnement UV-B et rayonnement UV-C proche, et (ii) au moins un autre des au moins trois différents ensembles (50) de dispositifs générateurs de lumière (100) est configuré pour générer un rayonnement ayant une longueur d'onde de pic dans la plage de longueur d'onde violette de 380 à 440 nm.

9. Système générateur de lumière (1000) selon l'une quelconque des revendications précédentes, dans lequel le matériau luminescent (200) comprend un matériau luminescent du type $A_3B_5O_{12}$:Ce, dans lequel A comprend un ou plusieurs parmi Y, La, Gd, Tb et Lu, et dans lequel B comprend un ou plusieurs parmi Al, Ga, In et Sc ; et dans lequel la lumière de système est de la lumière blanche ayant une température de couleur corrélée dans une plage allant de 1800 à 6500 K et un indice de restitution de couleurs d'au moins 80.

10. Système générateur de lumière (1000) selon l'une quelconque des revendications 1 à 9 précédentes, dans lequel tous les dispositifs générateurs de lumière (100) sont configurés en série.

11. Système générateur de lumière (1000) selon l'une quelconque des revendications 1 à 9 précédentes, dans lequel deux ou plus des au moins deux ensembles (50) de dispositifs générateurs de lumière (100) peuvent être commandés individuellement.

12. Système générateur de lumière (1000) selon l'une quelconque des revendications précédentes, comprenant un filament à DEL (1100), dans lequel le filament à DEL (1100) comprend le réseau (40) de dispositifs générateurs de lumière (100) ; dans lequel au moins les deuxièmes dispositifs générateurs de lumière (120) et les troisièmes dispositifs générateurs de lumière (130) sont configurés au niveau de l'une et/ou l'autre des parties de bout (1101,1102) du filament à DEL (1100).

13. Système générateur de lumière (1000) selon l'une quelconque des revendications précédentes, comprenant un dispositif générateur de lumière à puce sur carte (1400) comprenant le réseau (40) de dispositifs générateurs de lumière (100) ; dans lequel le système générateur de lumière (1000) comprend en outre une couche luminescente (1500) comprenant le matériau luminescent (200) configurée en aval du dispositif générateur de lumière à puce sur carte (1400) ; dans lequel la partie de réseau périphérique (62) ceint la partie de réseau centrale (61) ; dans lequel les premiers dispositifs générateurs de lumière (110) sont configurés dans la partie de réseau centrale (61) et dans lequel les autres dispositifs générateurs de lumière (120,130,140) sont configurés dans la partie de réseau périphérique (62), dans lequel la partie de réseau centrale (61) comprend un centre (63), dans lequel avec la distance du centre (63) qui augmente l'intensité d'excitation diminue ; et dans lequel x1 % est sélectionnée dans la plage de 20 à 80 %, et dans lequel x2 % est sélectionnée dans la plage de 20 à 80 %, dans lequel x1 et x2 sont tels que définis dans la revendication 5.

14. Système générateur de lumière (1000) selon l'une quelconque des revendications précédentes, dans lequel le matériau luminescent (200) a une surface de matériau luminescent (220), dans lequel un flux rayonnant de la lumière de matériau luminescent (201) sur 75 à 99 % de la surface de matériau luminescent (220) varie au sein d'une plage de +/- 15 % par rapport à un flux rayonnant moyen sur la surface de matériau luminescent (220).

15. Dispositif d'éclairage (1200) sélectionné dans le groupe d'une lampe (1), d'un luminaire (2) et d'un dispositif de communication optique sans fil, comprenant le système générateur de lumière (1000) selon l'une quelconque des revendications précédentes.

FIG. 1

FIG. 2

FIG. 3

FIG. 4

EP 4 548 394 B1

**REFERENCES CITED IN THE DESCRIPTION**

**Patent documents cited in the description**

- US 20190139943 A1
- US 11006493 B
- WO 2017131715 A1
- EP 3149108 A